(19) Europäisches Patentamt
European Patent Office
Office européen des brevets

(11) Veröffentlichungsnummer: **0 080 975**
**B1**

(12) # EUROPÄISCHE PATENTSCHRIFT

(45) Veröffentlichungstag der Patentschrift: **26.02.86**

(51) Int. Cl.[4]: **C 08 F 220/30**, G 03 F 7/10, C 07 C 69/757

(21) Anmeldenummer: **82810502.3**

(22) Anmeldetag: **24.11.82**

(54) **Lichtempfindliche Polymere.**

(30) Priorität: **30.11.81 CH 7653/81**

(43) Veröffentlichungstag der Anmeldung: **08.06.83 Patentblatt 83/23**

(45) Bekanntmachung des Hinweises auf die Patenterteilung: **26.02.86 Patentblatt 86/9**

(84) Benannte Vertragsstaaten: **CH DE FR GB IT LI NL**

(56) Entgegenhaltungen:
**EP - A - 0 014 673**
**US - A - 3 993 802**
**US - A - 4 075 012**

(73) Patentinhaber: **CIBA-GEIGY AG, Klybeckstrasse 141, CH-4002 Basel (CH)**

(72) Erfinder: **Finter, Jürgen, Dr., Zasiusstrasse 100, D-7800 Freiburg (DE)**

**EP 0 080 975 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

**Beschreibung**

Die Erfindung betrifft neue lichtempfindliche Polymere, ein Verfahren zu deren Herstellung, dabei einsetzbare neue Anthrachinonderivate sowie die Verwendung der neuen lichtempfindlichen Polymeren, vor allem zur Bilderzeugung.

Elektrisch leitende Ueberzüge und Muster, vor allem für gedruckte Schaltungen, können unter anderem dadurch hergestellt werden, dass man auf nicht-leitenden anorganischen oder organischen Substraten für die stromlose Metallabscheidung geeignete nullwertige Metallkeime erzeugt. Nach dem sogenannten Photoformation-Verfahren kann dies dadurch erfolgen, dass man auf das Substrat, gegebenenfalls in saurem Medium und in Gegenwart von Halogenidionen, Metallsalze, besonders Salze nicht-edler Metalle, wie Kupferformiat, abscheidet und anschliessend durch Bestrahlung, gegebenenfalls in Gegenwart chemischer Reduktionsmittel, zu nullwertigen Metallkeimen reduziert. Für die Reduktion der Metallsalze werden im allgemeinen lichtempfindliche Reduktionsmittel, ein zweites Reduktionsmittel und ein oberflächenaktives Mittel eingesetzt. Als lichtempfindliche Reduktionsmittel können u.a. Anthrachinondisulfonsäuren und Salze davon, gegebenenfalls im Gemisch mit Metallaktivatoren, wie Zinnsalzen, eingesetzt werden. Dabei müssen die Substrate im allgemeinen vor der Metallabscheidung angeätzt oder mit einer ätzbaren Haftvermittlerschicht versehen werden [intramolekulare photoreduktive Methode; vgl. z.B. US Patentschriften 3.959.547 und 3.993.502].

Gemäss einem weiteren vorbekannten Verfahren wird auf dem nichtleitenden Substrat eine Titandioxid enthaltende lichtempfindliche Schicht erzeugt oder Titandioxid wird in das Substrat eingearbeitet. Anschliessend muss das das Titandioxid enthaltende Substrat bzw. die das Titandioxid enthaltende Schicht angeätzt werden, um die $TiO_2$-Teil-chen für die weitere Behandlung zugänglich zu machen. Das angeätzte Material wird dann mit einer Lösung des gewünschten Metallsalzes behandelt und bestrahlt (Photoelektronen-Methode). Schliesslich können nullwertige Metallkeime auch dadurch erhalten werden, dass man auf dem nicht-leitenden Substrat zuerst ein lichtempfindliches Metallsalz, wie Zinn(II)hydroxid oder Eisenoxalat, abscheidet, durch Bestrahlung ein latentes Bild bzw. reduzierende Metallionen erzeugt und darauf durch Reduktion eines Metallsalzes, im allgemeinen eines Edelmetallsalzes, die nullwertigen Metallkeime erzeugt (photoelektrochemische Methode). Die so erhaltenen nullwertigen Metallkeime können anschliessend in an sich bekannter Weise durch stromlose Metallabscheidung metallisiert und die leitenden Bildstellen gegebenenfalls durch elektrolytische Metallabscheidung weiter verstärkt werden.

Es wurden nun neue lichtempfindliche Polymere gefunden, mit denen Abbildungen, besonders elektrisch leitende Ueberzüge und Muster, auf wesentlich einfachere und wirtschaftlichere Weise hergestellt werden können, wobei auf das Anätzen des Substrats oder die Verwendung von ätzbaren Haftvermittlerschichten verzichtet werden kann. Mit den neuen Polymeren erzeugte Abbildungen zeichnen sich zudem durch ein erhöhtes Auflösungsvermögen aus.

Gegenstand der Erfindung sind somit neue Polymere mit einer Grenzviskosität [η] von mindestens 0,10 dl/g, gemessen bei 25°C in N,N-Dimethylformamid, die aus 1 bis 40 Mo1% wiederkehrenden Strukturelementen der Formel I

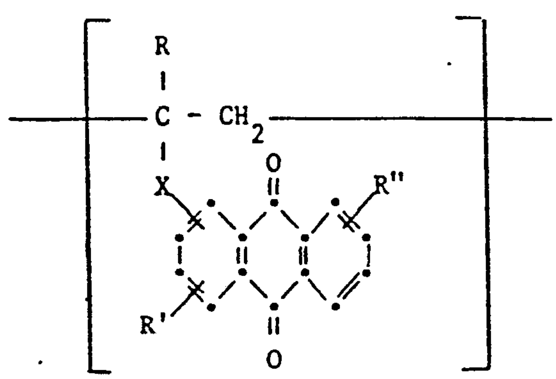

(I)

und 60 bis 99 Mo1.% wiederkehrenden Strukturelementen der Formel II

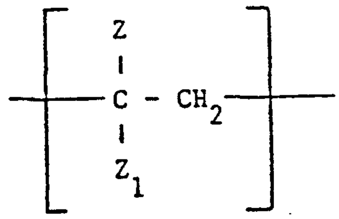 (II)

bestehen, worin
R Wasserstoff, Methyl oder Aethyl,
R' und R'' unabhängig voneinander Wasserstoff, $C_1$-$C_4$-Alkyl, Halogen, Nitro oder Methoxy,
X -COO-, -CO-O-$(CH_2)_n$-, -CO-O-$[(CH_2)_n$-O$]_r$-$CH_2$-, -CO-O-$[(CH_2)_n$-O$]_r$-,
-CO-O-$[CH_2CH(CH_3)O]_n$-, Phenylen-$CH_2$-O-, -CO-O-$[(CH_2)_n$-O$]_r$-CO-,
-CO-O-$[CH_2CH(CH_3)$-0$]_n$ – CO-, -CO-NR-, Phenylen-$CH_2$-0-$[(CH_2)_n$-O$]_r$ -$CH_2)_m$-,
Phenylen-$CH_2$-0-$[(CH_2)_n$-0$]_r$-CO-, -$COOCH_2CH(OH)CH_2OCO$-,
-$COOCH_2CH(OH)CH_2$0- oder
-CO-0-$[CH_2CH(CH_3)0]_r$-$CH_2$-,
m Null oder 1,
n eine ganze Zahl von 1-12,
r eine ganze Zahl von 1-4, bevorzugt 1,
Z Wasserstoff, Chlor oder Methyl,
$Z_1$ Wasserstoff, Chlor, Methyl, -CN, -COOH, -$CONH_2$, Phenyl, Methylphenyl, Methoxyphenyl, Cyclohexenyl, Imidazolyl, Pyrrolidonyl, -COO-Alkyl mit 1-12 C-Atomen im Alkyl, -COOPhenyl, -$COOCH_2$

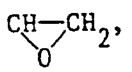

-COO-Alkylen-OH mit 2-12 C-Atomen im Alkylen,
-$COO(CH_2CH_20)_p$ – $_p$H oder -$COO[CH_2CH(CH_3)O]_p$- H mit p = 2-4,
-OCOAlkyl mit 1-4 C-Atomen im Alkyl,-OCOPhenyl, -COAlkyl mit 1-4
C-Atomen im Alkyl, $C_{1-12}$-Alkoxy, Phenoxy, Hydroxymethylphenyl,
-CONH-$C_{1-4}$-Alkylen-OH oder -COO-$C_{1-4}$-Alkylen-N(Q')(Q''),
Q' Wasserstoff oder $C_{1-5}$-Alkyl und Q'' $C_{1-5}$-Alkyl darstellen, wobei Z in mindestens 20 % der Strukturelemente der Formel II -COO-$C_{2-12}$-Alkylen-OH, -$COO(CH_2CH_20)_p$– H, -$COO[CH_2CH(CH_3)0]_p$-H, Hydroxymethylphenyl, -CONH-$C_{1-4}$-Alkylen-OH oder -COO-$C_{1-4}$-Alkylen-N-(Q,)(Q'') bedeutet und die Strukturelemente der Formel II mindestens teilweise mit Metallionen eines Metalls der Gruppe VIII oder Ib des Periodensystems komplexiert sein können, mit der Massgabe, dass $Z_1$, wenn X -CO-O-$CH_2$- darstellt, in höchstens 50 % der Strukturelemente der Formel II -$COOCH_2CH_2OH$ darstellt.

Stellen R' und/oder R'' Halogen dar, so handelt es sich insbesondere um Chlor- oder Bromatome, Alkylgruppen R' und R'', Alkoxygruppen $Z_1$ und Alkyl- oder Alkylengruppen in Resten $Z_1$ können geradkettig oder verzweigt sein. Beispiele von geeigneten Alkylgruppen R' und R'' sind Methyl, Aethyl, n-Propyl, Isopropyl, n-Butyl und sek-Butyl. Alkylgruppen R' und R'' sind bevorzugt geradkettig und weisen 1 oder 2 C-Atome auf. Besonders bevorzugt stellen R' und R'' je Wasserstoff dar. Stellt $Z_1$ definitionsgemässes -COOAlkyl, -COO-Alkylen-OH, -$COO(CH_2CH_20)_p$-H, -$COO[CH_2CH(CH_3)O]_p$- H, -OCO-Alkyl,
-COAlkyl, Alkoxy, -CONH-$C_{1-4}$-Alkylen-OH oder -COO-Alkylen-N(Q')(Q'') dar, so handelt es sich beispielsweise um die folgenden Reste:
-COOMethyl, -COOAethyl, -COO-n-Propyl, -COOIsopropyl, -COO-n-Butyl,
-COO-n-Pentyl, -COO-n-Hexyl, -COO-2-Aethylhexyl, -COO-n-Octyl,
-COO-n-Decyl, -COO-n-Dodecyl; -$COOCH_2CH_2OH$, -$COOCH_2CH(OH)CH_3$,
-$COO(CH_2)_3$-OH, -$COOCH(CH_3)_2$-OH, -$COOCH_2CH(CH_3)_2$-OH, -$COO(CH_2)_4$-OH,
-$COO(CH_2)_6$-OH, -$COO(CH_2)_8$-OH, -$COO(CH_2)_{10}$-OH, -$COO(CH_2)_{12}$-OH; -$OCOCH_3$,
-$OCOC_2H_5$, -OCO-n-Propyl, -OCO-Isopropyl, -OCO-n-Butyl; -$COCH_3$,
-$COC_2H_5$-, -CO-n-ProPyl, -CO-Isopropyl, -CO-n-Butyl; Methoxy, Aethoxy,
n-Propoxy, Isopropoxy, n-Butoxy, n-Hexyloxy, 2-Aethylhexyloxy,
n-Octyloxy, n-Decyloxy, n-Dodecyloxy; -CONH-$(CH_2)_2$-OH, -CONH-$(CH_2)_3$-OH
-CONH-$(CH_2)_4$-OH; -$COO(CH_2)_2N(-CH_3)_2$, -$COO(CH_2)_2N(_2H_5)_2$,
-$COO(CH_2)_3N(CH_3)_2$, -$COO(CH_2)_2$N(n-Propyl)$_2$ -$COO(CH_2)_4N(CH_3)_2$,

$-COO(CH_2CH_20)_2-H$, $-COO[CH_2CH(CH_3)0]_2-H$ $-COO(CH\ CH_2O)_3-H$ und $-COO[CH_2CH(CH_3)O]_3-H$.
X ist bevorzugt in 2-Stellung an den Anthrachinonrest gebunden.
X ist wie folgt an die Gruppe

$-\overset{|}{C}(R)-$ gebunden:

X = Phenylen-$CH_2$-0-$[(CH_2)_n$-O$)^r$-$(CH_2)$-, Phenylen-$CH_2$-O- oder Phenylen-$CH_2$-O-$[(CH_2)_n$-O$]_r$-CO: über die Phenylengruppe;
übrige Bedeutungen von X: über die Carbonylgruppe.

Die erfindungsgemässen Polymeren weisen bevorzugt eine Grenzviskosität von 0,30 bis 0,50 dl/g, gemessen bei 25°C in N N-Dimethylformamid (DMF) auf. Das durchschnittliche Molekulargewicht der Polymeren liegt im allgemeinen zwischen 10 000 und 1 000 000, insbesondere 150 000 und 300 000 Dalton. Das durchschnittliche Molekulargewicht der Polymeren kann nach an sich bekannten Methoden bestimmt werden, z.B. mittels Lichtstreuung.

Der Anteil an Strukturelementen der Formel I liegt bei definitionsgemäss komplexierten Polymeren bevorzugt zwischen 1 und 15, besonders 1 und 10 Mol%. Bei nicht komplexierten Polymeren beträgt der Anteil an Strukturelementen der Formel I zweckmässig bis 40 und vor allem 3 bis 35 Mol%. Als Strukturelemente der Formel I werden solche bevorzugt, worin X in 2-Stellung an den Anthrachinonrest gebunden ist, R Wasserstoff und besonders Methyl, R' und R'' je Wasserstoff, X -COO-, -COO-$[CH_2CH(CH_3)$-0$]_n$- oder -COO-$[(CH_2)_n$-0$]_r$- mit n = 1-11, besonders 1-8, -COO-$CH_2$-, -COO-$[(CH_2)$ -O$]_r$-CO- oder -COO-$[(CH_2)_n$ -O$]_r$-$CH_2$- mit n = 2-8 oder Phenylen-$CH_2$-O- bedeuten, wobei r vorzugsweise 1 ist. Ganz besonders bevorzugt stellt X -COO- oder Phenylen-$CH_2$-O- dar.

$Z_1$ bedeutet vorzugsweise in 20 bis 97,5 und insbesondere 20 bis 70 % der Strukturelemente der Formel II -COO-$C_{2-12}$-Alkylen-OH, Hydroxymethylphenyl, -CONH-$C_{1\ 4}$-Alkylen-OH, -COO-$C_{1-4}$-Alkylen-N(Q')(Q''), -COO$(CH_2CH_2O)_p$- H oder -COO$[CH_2CH(CH_3)O\ ]_p$-H.

Bevorzugte Strukturelemente der Formel II sind solche, worin Z Wasserstoff Chlor oder Methyl und $Z_1$ Wasserstoff, Chlor,-CN, Methyl, Phenyl, Methylphenyl, Methoxyphenyl, -COO-$C_{1-10}$-Alkyl, -COOPhenyl, -$COOCH_2$

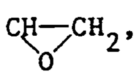

-COO-$C_{2-12}$-Alkylen-OH, -CO-Alkyl mit 1-4 und besonders einem oder zwei C-Atomen, Alkoxy mit 1-8 und besonders 1-4 C-Atomen, Phenoxy, Hydroxymethylphenyl, -CONH$(CH_2)_2$-OH oder -COO-$C_{1-4}$-Alkylen-N$(C_{1-4}$-Alkyl$)_2$ darstellen, wobei der Anteil an Gruppen $Z_1$ = -COO-$C_{2-12}$-Alkylen-OH, Hydroxymethylphenyl, -CONH$(CH_2)_2$-OH oder -COO-$C_{1-4}$-Alkylen-N$(C_{1-4}$-Alkyl$)_2$ 20 bis 70 % beträgt.

Besonders bevorzugt sind Strukturelemente der Formel II, worin Z Wasserstoff oder Methyl und $Z_1$ Methyl, Phenyl, Methylphenyl, -COO-$C_{1-10}$-Alkyl, -COO-$C_{2-12}$-Alkylen-OH, Hydroxymethylphenyl oder -COO-$C_{1-4}$-Alkylen-N$(CH_3)_2$ darstellen, wobei der Anteil an Gruppen -COO-$C_{2-12}$-Alkylen-OH, Hydroxymethylphenyl oder -COO-$C_{1-4}$-Alkylen-N$(CH_3)_2$ 20 bis 70% beträgt.

Für die allfällige Komplexierung der erfindungsgemässen Polymeren eignen sich Salze der definitionsgemässen Metalle mit organischen oder anorganischen Säuren oder Gemische davon, wie Carboxylate, z.B. Formiate, Acetate, Stearate, Gluconate und Citrate; Halogenide, Nitrate, Sulfate und Perchlorate. Als Beispiele seien genannt: Eisen(III)acetat, -citrat, -gluconat, -nitrat, -sulfat und -perchlorat; Eisen(II)- oder Eisen(III)chlorid, Eisen(II)oxalat; Ruthenium(III)chlorid; Kobalt(II)acetat, -nitrat oder -sulfat; Kobalt(II)chlorid oder -bromid; Rhodium(II)acetat, Rhodium(III)chlorid; Nickel(II)acetat, Nickel(II)bromid und -chlorid, Nickel(II)sulfat; Palladium(II)chlorid und -jodid, Palladiumacetat und -nitrat; Kupfer(II)formiat und -acetat, Kupfer(I)oder -(II)chlorid, -bromid und -jodid, Kupfer(II)nitrat oder -sulfat; Silberacetat, -chlorid, -bromid, -nitrat oder -sulfat.

Bevorzugt sind die erfindungsgemässen Polymeren mindestens teilweise mit Nicht-Edelmetall-Ionen komplexiert, vor allem Eisen-, Kobalt-, Nickel- oder Kupferionen. Ganz besonders bevorzugt sind $Cu^{++}$-Ionen.

Besonders geeignet für die Komplexierung sind Carboxylate, vor allem die Acetate, gegebenenfalls im Gemisch mit Halogeniden, besonders Bromiden oder Chloriden. Ganz besonders bevorzugt verwendet man für die Komplexierung Kupfer(II)acetat oder Gemische aus Kupfer(II)acetat und Kupfer(II)bromid, wobei das Verhältnis von Kupfer(II)acetat zu Kupfer(II)bromid zweckmässig zwischen 1:8 und 1:100 liegt. Der Grad der Komplexierung beträgt vorzugsweise bis zu 15% der komplexierbaren OH- oder sekundären bzw. tertiären Aminogruppen.

Besonders bevorzugt sind einerseits erfindungsgemässe Polymere mit einer Grenzviskosität [η] von 0,30 bis 0,50 dl/g, gemessen bei 25°C in DMF, die aus 2 bis 10 Mol% wiederkehrenden Strukturelementen der Formel I und 90 bis 98 Mol% wiederkehrenden Strukturelementen der Formel II bestehen, worin X in 2-Stellung an den Anthrachinonrest gebunden ist R Wasserstoff und vor allem Methyl R' und R'' je Wasserstoff und X -COO-, $-COO[(CH_2CH(CH_3)-O]_n-$ oder $-COO[(CH_2)_n-O]_2-$ mit n = 1-11, $-COOCH_2-$, $-COO[(CH_2)_n-O]_r-CO-$ oder $-COO[(CH_2)_n-O]_r-CH_2-$ mit n = 2-8 oder Phenylen-$CH_2$-O- und vor allem -COO- oder Phenylen-$CH_2$-O- bedeuten, in 55-65% der Strukturelemente der Formel II Z Wasserstoff und besonders Methyl und $Z_1$ $-COO(CH_2)_2-N(CH_3)_2$ und vor allem $-COO(CH_2)_2-OH$ und in 35-45% der Strukturelemente der Formel II Z Methyl und insbesondere Wasserstoff und $Z_1$ Phenyl oder -COO-$C_{1-8}$-Alkyl, besonders -COOMethyl, -COOAethyl oder -COO-2-Aethylhexyl darstellen, wobei die Strukturelemente der Formel II mindestens teilweise, bevorzugt zu 5 bis 15%, mit Eisen-, Kobalt-, Nickel- oder Kupferionen, besonders $Cu^{++}$-Ionen, komplexiert sind. Dabei ist r bevorzugt 1.

Unter den nicht-komplexierten erfindungsgemässen Polymeren sind solche mit einer Grenzviskosität von 0,30 bis 0,50 dl/g bevorzugt, die aus 3-40 Mol% wiederkehrenden Strukturelementen der Formel I und 60-97 Mol% wiederkehrenden Strukturelementen der Formel II bestehen, worin X in 2-Stellung an den Anthrachinonrest gebunden ist, R Wasserstoff und vor allem Methyl, R' und R'' je Wasserstoff und X -COO-, $-COO[CH_2CH(CH_3)-O]_n-$ oder $-COO[(CH_2)_n-O]_r-$ mit n = 1-11, $-COO-CH_2-$, $-COO-[(CH_2)_n-O]$ -CO- oder $-COO[(CH_2)_n-O]_r-CH_2-$ mit n = 2-8 oder Phenylen-$CH_2$-O- bedeuten, wobei r 1-4 und insbesondere 1 ist, in 20-65% der Strukturelemente der Formel II Z Wasserstoff und besonders Methyl und $Z_1$ $-COO(CH_2)_2N(CH_3)_2$ und vor allem $-COO(CH_2)_2-OH$ und in 35-80% der Strukturelemente Z Methyl und insbesondere Wasserstoff und $Z_1$ Phenyl oder -COO-$C_{1-8}$-Alkyl darstellen.

Die erfindungsgemässen Polymeren können auf an sich bekannte Weise dadurch hergestellt werden, dass man 1 bis 40 Mol% einer Verbindung der Formel Ia

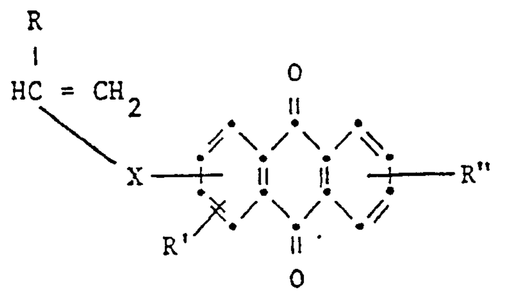

(Ia)

mit 60 bis 99 Mol% einer Verbindung der Formel IIa

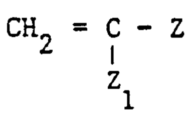

(IIa)

polymerisiert und das erhaltene Polymere gegebenenfalls anschliessend mindestens teilweise mit einem Salz eines Metalls der Gruppe VIII oder Ib des Periodischen Systems komplexiert. Dabei gilt in Bezug auf m, n, r, R, R', R'', X, Z und $Z_1$ und den Anteil an Gruppen -COO-$C_{2-12}$-Alkylen-OH, $-COO(CH_2CH_2O)_p-H$, -$COO[CH_2CH(CH_3)O]_p-H$ Hydroxymethylphenyl, -CONH-$C_{1-4}$-Alkylen-OH oder -COO-$C_{1-4}$-Alkylen-N-(Q')(Q'') das unter den Formeln I und II Angegebene. Die Komplexierung der Strukturelemente der Formel II kann vor oder bevorzugt während der Applikation der erfindungsgemässen Polymeren erfolgen.

Die Polymerisation kann nach üblichen Methoden vorgenommen werden, z.B. in Gegenwart radikalischer oder ionischer Initiatoren. Bevorzugt ist die radikalische Polymerisation. Dabei verwendet man zweckmässig etwa 0,01 bis 5 Gew.%, vorzugsweise 0,01 bis 1,5 Gew.%, bezogen auf das Gesamtgewicht der Monomeren, an sich bekannter Radikalinitiatoren, wie anorganische oder organische Peroxide oder Azoverbindungen, z.B. Wasserstoffperoxid, Kaliumperoxidisulfat, tert.-Butylhydroperoxid, Di-tert.-butylperoxid, Peressigsäure, Dibenzoylperoxid, Diacrylperoxide, Cumolhydroperoxid, tert.-Butylperbenzoat, tert.-Alkylperoxidcarbonate und α,α'-Azoisobutyronitril. Die Reaktionstemperaturen für die radikalische Polymerisation liegen im allgemeinen zwischen etwa 30 und 100°C. Die radikalische Polymerisation kann aber auch in der Kälte durchgeführt werden, wozu man auch Redoxsysteme in den oben genannten Konzentrationen verwenden kann, z.B. Gemische aus Peroxiden, wie Wasserstoffperoxid, und einem Reduktionsmittel, wie zweiwertige Eisenionen. Die

Polymerisation kann in homogener Phase, z.B. in Substanz oder in Lösung, oder in heterogener Phase, d.h. als Fällungspolymerisation, Emulsions- oder Suspensionspolymerisation, erfolgen. Bevorzugt ist die Polymerisation in Lösung.

Geeignete Lösungsmittel sind z.B. cyclische Aether, wie Tetrahydropyran, Tetrahydrofuran und Dioxan, aliphatische und cyclische Amide, wie N,N-Dimethylformamid, N,N-Dimethylacetamid und N-Methylpyrrolidon; Diacetonalkohol und Chloroform.

Erfindungsgemässe polymere, worin $Z_1$ ungleich -COOH, -$CONH_2$, -COO-$C_{1-12}$-Alkyl, -COOPhenyl oder -$COOCH_2$

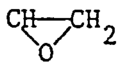

und X ungleich -$COOCH_2CH(OH)CH_2OCO$- sind, können auch dadurch erhalten werden, dass man den Anthrachinonrest in schon bestehende Polymere mit geeigneten funktionellen Gruppen einbaut. Dabei setzt man in an sich bekannter Weise Polymere, die aus 1 bis 40 Mol% wiederkehrenden Strukturelementen der Formel Ib

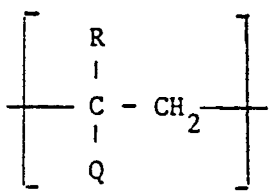

(Ib)

und 60 bis 99 Mol% wiederkehrenden Strukturelementen der Formel IIb

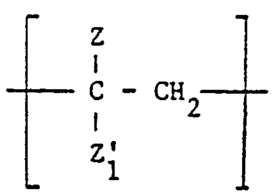

(IIb)

bestehen, mit einer Verbindung der Formel III

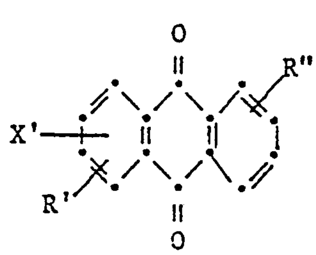

(III)

um und komplexiert das erhaltene Polymere gegebenenfalls anschliessend mindestens teilweise mit einem Salz eines Metalls der Gruppe VIII oder Ib des Periodischen Systems. In den obigen Formeln Ib, IIb und III gilt in

Bezug auf m, n, R, R', R'' und Z und den Anteil an Gruppen $-COO-C_{2\ 12}$-Alkylen-OH, $-COO(CH_2CH_2O)_p-H$, $-COO[CH_2CH(CH_3)O]_p-H$,
Hydroxymethylphenyl, $-CONH-C_{1-4}$-Alkylen-OH oder $-COO-C_{1-4}$-Alkylen-N-(Q')(Q'') das unter den Formeln I und II Angegebene, Q stellt -COHalogen, Phenylen-$CH_2$-Halogen oder $-COOCH_2$

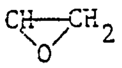

dar,
wobei Halogen bevorzugt Chlor ist,
X' bedeutet HO-, $HO-(CH_2)_n-$, $HO-[(CH_2)_n-O]_r-CH_2-$, $HO-[CH_2CH(CH_3)_r-O]-CH_2-$, $HO-[(CH_2)_n-O]_r-$, $HO[CH_2CH(CH_3)-O]_n-$, $HO-[(CH_2)_n-O]_r-CO-$, $HO-[CH_2CH(CH_3)-O]_n-CO-$ oder HNR- und
$Z'_1$ hat dieselbe Bedeutung wie $Z_1$, ist aber ungleich -COOH, $-CONH_2$, $-COO-C_{1-12}$-Alkyl, -COOPhenyl oder $-COOCH_2$

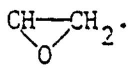

Schliesslich können Polymere, worin Z Wasserstoff oder Methyl und
X $-COOCH_2CH(OH)CH_2-OCO-$, $-COO-[(CH_2)_n-O]_r-CH_2-$, $-COO-[(CH_2)_n-O]_rCO-$, $-COO-[CH_2CH(CH_3)-O]_r-CH_2-$,
$-COO[CH_2CH(CH_3)O]_n-CO-$, Phenylen-$CH_2-O[(CH_2)_n-O]_r-CH_2-$ oder Phenylen-$CH_2-O-[(CH_2)_n-O]_r-CO-$ darstellen, auch dadurch hergestelltwerden, dass man ein Polymeres, das aus 1-40 Mol % wiederkehrenden Strukturelementen der Formel Ic

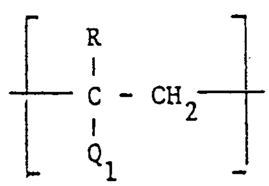

(Ic)

und 60-99 Mol% wiederkehrenden Strukturelementen der Formel IIc

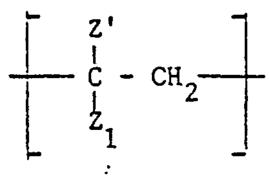

(IIc)

besteht, mit 1-40 Mol% einer Verbindung der Formel IIIa

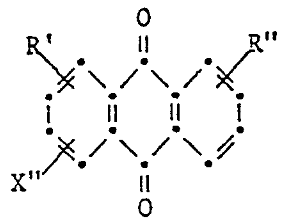

(IIIa)

umsetzt und das so erhaltene Polymere gegebenenfalls anschliessend mindestens teilweise mit einem Salz eines Metalls der Gruppe VIII oder Ib des Periodischen Systems komplexiert. In den obigen Formeln Ic, IIc und IIIa gilt in Bezug auf n, r, R, R', R'' und Z und den Anteil an Gruppen -COO-$C_{2-12}$-Alkylen-OH, -COO$(CH_2CH_2O)_p$-H, -COO$[CH_2CH(CH_3)O]_p$-H, Hydroxymethylphenyl, -CONH-$C_{1-4}$-Alkylen-OH oder -COO-$C_{1-4}$-Alkylen-N(Q,)(Q'') das unter den Formeln I und II Angegebene, Z' ist Wasserstoff oder Methyl,

$Q_1$ stellt -$COOCH_2$

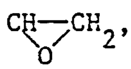,

-COO-$[(CH_2)_n$-O$]_r$-H, -COO-$[CH_2CH(CH_3)$-O$]_n$-H,
-COO$[CH_2CH(CH_3)$-O$]_r$-H oder Phenylen-$CH_2$-O-$[(CH_2)_n$-O$]_r$-H dar und X''
bedeutet: wenn $Q_1$ - $COOCH_2$

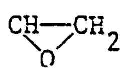

ist, -COOH; wenn
$Q_1$ -COO$[(CH_2)_n$-O$]_r$-H, -COO$[CH_2CH(CH_3)$-O$]_r$-H oder Phenylen-$CH_2$-O-$[(CH_2)_n$-O$]_r$-H ist, -COOH, -COCl oder -$CH_2Cl$; wenn
$Q_1$ -COO$[CH_2CH(CH_3)$-O$]_n$-H ist, -COOH oder -COCl.

Die Verbindungen der Formeln Ia, IIa, III und IIIa sowie die Polymeren aus Strukturelementen der Formeln Ib, Ic, IIb und IIc sind bekannt oder können nach an sich bekannten Methoden hergestellt werden. Verbindungen der Formel Ia können z.B. dadurch erhalten werden, dass man Anthrachinonderivate der Formel III mit Monomeren der Formel Id

$$Q - \overset{\displaystyle R}{\overset{|}{C}} = CH_2 \qquad \text{(Id)}$$

umsetzt, wobei R und Q die oben angegebene Bedeutung haben. Gegenstand der Erfindung sind auch die neuen Monomeren der Formel Ia, worin R, R' und R'' die unter Formel I angegebene Bedeutung haben und X
-CO-O$(CH_2)_{n'}$-, -CO-O-$[(CH_2)_n$-O$]_r$-$CH_2$-, -CO-O-$[(CH_2)_n$ O$]_r$
-CO-0-$[CH_2CH(CH_3)$-O$]_r$-$CH_2$-, -CO-O-[-$CH_2CH(CH_3)$-O-$]_n$—, Phenylen-$CH_2$-O-,
-CO-O-$[(CH_2)_n$-O$]_r$-CO-, -CO-O-$[CH_2CH(CH_3)$-O$]_n$-CO-, -CO-NR-,
Phenylen-$CH_2$-O$[(CH_2)_n$-O$]_r$-$(CH_2)_m$-, Phenylen-$CH_2$-O-$[(CH_2)_n$-O$]_r$-CO- oder
-CO-O-$CH_2CH(OH)CH_2OCO$-, m Null oder 1, r eine ganze Zahl von 1-4,
n eine ganze Zahl von 1-12 und n' eine ganze Zahl von 2-12 bedeuten.

Dabei gilt in Bezug auf bevorzugte Bedeutungen von R, R' R'' und X dasunter Formel I Angegebene.

Die erfindungsgemässen lichtempfindlichen Polymeren finden z.B. Anwendung als Sensibilisatoren (Redox-Katalysatoren) bei verschiedenen Oxidations-/Reduktionsreaktionen oder als Beschichtungsmaterialien, z.B. für den Korrosionsschutz von Photohalbleiterdioden oder Halbleiterlaser. Besonders eignen sie sich aber zur Bilderzeugung durch Lichteinwirkung auf verschiedenen anorganischen oder organischen Substraten. Geeignete Substrate für die Bilderzeugung sind z.B. Glas, Metalle und Metalloxide, wie Aluminium,

Aluminiumoxid und Kupfer, Keramik, Papier und hochmolekulare organische Materialien. Als hochmolekulare organische Materialien kommen natürliche und synthetische Polymere in Betracht, z.B. Cellulosematerialien, wie Celluloseacetate, Cellulosepropionate, Cellulosebutyrate und Celluloseäther, wie Methylcellulose; von $\alpha,\beta$-ungesättigten Säuren abgeleitete Polymere, wie Polyacrylate und Polymethacrylate, Polyacrylamide und Polyacrylnitril; Styrolpolymere und Copolymere davon, z.B. Styrol/Butadiencopolymere und Acrylnitril/Butadien/Styrolcopolymere; Vinyl- und Vinylidenpolymere und Copolymere davon, wie Polyvinylchlorid, Polyvinylidenchlorid, Vinylchlorid/Vinylidenchloridcopolymere, Vinylchlorid/Vinylacetatcopolymere; von ungesättigten Alkoholen und Aminen abgeleitete Polymere und Derivate davon, wie Polyvinylalkohol, Polyvinylacetat und Polyallylmelamin; vernetzte Epoxidharze; Polyacetale; Polyalkylenoxide und Polyphenylenoxide; Polyamide, Polyimide, Polyamid-Polyimid-Blockcopolymere, Polysulfone und Polyester; Alkydharze, z.B. Glycerin/ Phthalsäureharze und deren Mischungen mit Melamin/Formaldehydharzen, Melamin-Formaldehyd-, Harnstoff-Formaldehyd-, Phenol-Formaldehydharze, usw.

Die erfindungsgemässen Polymeren finden vor allem Anwendung zur Erzeugung von elektrisch leitenden Ueberzügen oder Mustern, besonders gedruckten Schaltungen. Zu diesem Zweck werden in an sich bekannter Weise unter Lichteinwirkung die Metallionen der mindestens teilweise komplexierten erfindungsgemässen Polymeren zu nullwertigen nichtleitenden Metallkeimen (nicht-leitenden sichtbaren Bildstellen) reduziert oder es werden bei nicht komplexierten erfindungsgemässen Polymeren Radikale erzeugt, auf denen dann in üblicher Weise durch strom Silber, Zinn usw., elektrisch leitende metallische Ueberzüge oder Muster hergestellt werden können. Diese metallischen Ueberzüge oder Muster können gewünschtenfalls durch elektrolytische Metallabscheidungsbäder verstärkt werden. Für die Belichtung der erfindungsgemässen Polymeren können an sich beliebige geeignete Lichtquellen eingesetzt werden, z.B. Xenonlampen, Metallhalogenidlampen und besonders Quecksilberhoch- und -mitteldrucklampen.

**A) Herstellung von Verbindungen der Formel Ia**

**Beispiel 1: Herstellung von (2-Anthrachinonyl)-4-oxa-3-oxo-2-methylbuten-1**

In einem 1000 ml Braunglaskolben mit Tropftrichter und Thermometer werden unter Inertgas 0,2 Mol 2-Hydroxyanthrachinon in 600 ml Pyridin gelöst. Unter Eiskühlung werden dann 0,24 Mol Methacrylsäurechlorid innerhalb von 15 Minuten zugetropft. Nach 20 Std. Rühren bei Raumtemperatur wird das Pyridin an einem Rotationsverdampfer entfernt. Das kristalline Rohprodukt wird in 500 ml 0,1 N HCl suspendiert, filtriert, erneut mit Wasser aufgenommen und nach dem Waschen mit Natriumbicarbonatlösung und Wasser im Vakuum getrocknet. Ausbeute an Rohprodukt 90 % d.Th. Die Umkristallisation des Rohproduktes aus Aethylenglykolmonomethyläther ergibt in 58 %iger Ausbeute Methacryl-säure-(2-anthrachinonyl)-ester als gelbes kristallines Produkt; Smp. 184-186°C.

$\varepsilon_{254}$ = 50200, $\varepsilon_{325}$ = 5200 in Aethanol.

Analyse: berechnet C 73,97 H 4,14 0 21,90

gefunden C 73,85 H 4,16 0 22,12.

**Beispiel 2: Herstellung von (1-Anthrachinonyl)-4-oxa-3-oxo-2methyl-buten-1**

Unter Verwendung von 0,2 Mol 1-Hydroxyanthrachinon wird nach der in Beispiel 1 beschriebenen Arbeitsweise (1-Anthrachinonyl)-4-oxa-3-oxo-2-methyl-buten-1 hergestellt. Nach dem Umkristallisieren erhält man 54,7 % Produkt vom Smp. 187-189°C.

$\varepsilon_{252}$ 43000 $\varepsilon_{331}$ = 5400 in Chloroform.

Analyse: berechnet C 73,97 H 4,14 0 21 90

gefunden C 73,88 H 4,20 0 21,90.

**Beispiel 3: Herstellung von (2-Anthrachinonyl)-5-oxa-4-oxo-3methyl-penten-1**

Die Herstellung erfolgt nach der Methode von G.Izoret, Ann. Chim. 7, 180 (1962).

**Beispiel 4: Herstellung von m-/p-Methylstyryl-1-anthrachinonyl-äther**

In einem 1 Liter Braunglaskolben mit mechanischem Rührer, Thermometer und Kühler werden 0,1 Mol 1-Hydroxyanthrachinon in 100 ml N-Methylpyrrolidon heiss gelöst. Nach dem Abkühlen auf Raumtemperatur wird portionenweise 0,1 Mol NaH-Suspension zugegeben. Nach Beendigung der Gasentwicklung werden 0,11 Mol

eines Gemisches von 3- und 4-Vinyl-benzylchlorid zugegeben und 5 Std. bei 100°C gerührt. Man lässt über Nacht bei Raumtemperatur rühren. Danach gibt man 100 ml 0,1 N HCl zu, und die so entstandene Suspension wird mehrfach mit Methylenchlorid ausgeschüttelt. Nach dem Neutralisieren mit Natriumbicarbonatlösung, dem Trocknen mit $Na_2SO_4$ und Abziehen des Methylenchlorids verbleibt ein Oel, aus dem mit Wasser ein gelbes kristallines Produkt gefällt wird. Rohausbeute 33,7 g (99% d.Th.). Das Rohprodukt wird durch Säulenchromatographie mit Methylenchlorid gereinigt; Ausbeute an m-/p-Methylstyryl-1-anthrachinonyläther = 58% d.Th., Smp. 88-90°C.

Analyse: berechnet C 81,16 H 4,74 0 14,10
gefunden C 81,10 H 4,96 0 14,12.

**Beispiel 5: Herstellung von m-/p-Methylstyryl-2-anthrachinonyl-äther**

Unter Verwendung von 2-Hydroxyanthrachinon anstelle von 1-Hydroxy-anthrachinon wird nach der in Beispiel 4 beschriebenen Arbeitsweise der m-/p-Methylstyryl-2-anthrachinonyl-äther hergestellt. Ausbeute 45% d.Th., Smp. 97-99°C (unkorr.).

Analyse: berechnet C 81,16 H 4,74 0 14,10
gefunden C 80,96 H 4,64 0 14,15.

**Beispiel 6: Herstellung von (2-Anthrachinonyl)-7-oxa-4-oxa-3-oxo-2methyl-hepten-1**

0,25 Mol 2-Hydroxyanthrachinon werden in 200 ml N-Methylpyrrolidon gelöst und unter Inertgas portionenweise mit 0,25 Mol NaH versetzt. Die Temperatur übersteigt 40°C nicht. Nach Beendigung der Gasentwicklung werden 0,375 Mol 2-Chloräthanol zugegeben und das Reaktionsgemisch wird 5 Std. auf 70°C gehalten. Nach dem Abkühlen auf Raumtemperatur wird der Ansatz in 2 Liter 0,01 N HCl gegeben. Das ausgefallene Produkt wird abfiltriert, mit Natriumbicarbonatlösung gewaschen und getrocknet. Zur Herstellung des Methacrylsäureesters wird das so erhaltene Rohprodukt wie in Beispiel 1 beschrieben in Pyridin mit Methacrylsäurechlorid umgesetzt. Nach dem Umkristallisieren aus Aethylenglykolmonomethyläther erhält man das (2-Anthra-chinonyl)-7-oxa-4-oxa-3-oxo-2-methyl-hepten-1 in einer Ausbeute von 56,12 % d.Th.; Smp. 122°C.

Analyse: berechnet C 71,42 H 4,80 0 23,79
gebunden C 71,27 H 4,78 0 22,64.

**Beispiel 7: Herstellung von (2-Anthrachinonyl)-11-oxa-4-oxa-3-oxo-2-methyl-undecen-1**

Unter Verwendung von 6-Chlorhexanol anstelle von 2-Chloräthanol wird nach der in Beispiel 6 beschriebenen Arbeitsweise das (2-Anthrachinon-yl)-11-oxa-4-oxa-3-oxo-2-methyl-undecen-1 hergestellt; Ausbeute 54,81 % d. Th. (nach dem Umkristallisieren aus Methanol). Smp. 79°C.

Analyse: berechnet C 73,45 H 6,16 0 20,38
gefunden C 73,27 H 6,36 0 20,61.

**Beispiel 8: Herstellung von (2-Anthrachinonyl)-8-oxo-7-oxa-4-oxa-3-oxo-2-methyl-octen-1**

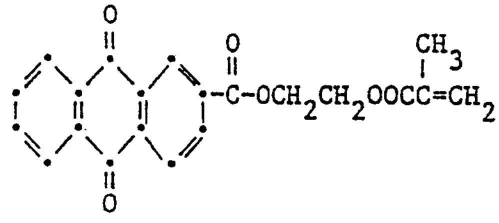

30 g (0,12 Mol) 2-Anthrachinoncarbonsäure werden unter Feuchtigkeitsausschluss bei 0°C in 100 ml Thionylchlorid aufgeschlämmt. Nach Zugabe von 2 ml N,N-Dimethylformamid (DMF) wird langsam zum

Rückfluss erhitzt. Es entsteht eine klare Lösung. Ueberschüssiges Thionylchlorid wird durch Vakuumdestillation entfernt, und der Rückstand wird aus Toluol umkristallisiert. Man erhält 27 g 2-Anthrachi-noncarbonsäurechlorid. Zu einer Lösung von 27 g (0,1 Mol) 2-Anthra-chinoncarbonsäurechlorid in 200 ml Methylenchlorid wird ein Gemisch aus 17 g (0,15 Mol) Methacrylsäurehydroxyäthylester, 30 ml (0,2 Mol) Triäthylamin und 50 ml Methylenchlorid so zugetropft, dass die Temperatur des Reaktionsgemisches 10°C nicht übersteigt. Dann wird mit angesäuertem Eiswasser versetzt, die organische Phase wird mehrfach mit Wasser und Natriumbicarbonatlösung gewaschen und über Natriumsulfat getrocknet. Nach dem Abziehen des Methylenchlorids und Umkristallisieren des Rückstands aus Aethanol erhält man den Methacrylsäurehydroxyäthylester der 2-Anthrachinoncarbonsäure in einer Ausbeute von 72% d.Th., Smp. 119-120°C.

Analyse: berechnet C 69,23 H 4,43 0 26,35
gefunden C 69,4 H 4,5 0 26,6.

**Beispiel 9: Herstellung von (2-Anthrachinonyl)-9-oxo-8-oxa-4-oxa-3-oxo-2-methyl-nonen-1**

Unter Verwendung von Methacrylsäurehydroxypropylester anstelle des Methacrylsäurehydroxyäthylesters wird nach dem in Beispiel 8 beschriebenen Verfahren der Methacrylsäurehydroxypropylester der 2-Anthrachinoncarbonsäure hergestellt; Ausbeute 76% d.Th., Smp.88-92°C.

Analyse: berechnet C 69,84 H 4,80 0 25,37
gefunden C 69,65 H 4,87 0 25,40.

**Beispiel 10: Herstellung von (2-Anthrachinonyl)-16-oxa-4-oxa-3-oxo-2-methyl-hexadecen-1**

Nach dem in Beispiel 6 beschriebenen Verfahren werden 0,25 Mol 2-Hydroxyanthrachinon und 0,4 Mol 11-Bromundecanol-1 zum (2-Anthra-chinonyl)-12-oxa-dodecanol-1 umgesetzt. Nach dem Umkristallisieren in Methanol erhält man 79,1 g (80% d.Th.) Produkt;$\varepsilon_{max}$ 34600 (270 nm), 3600 (330 nm), 3200 (370 nm).

Analyse: berechnet C 76,11 H 7,66 0 16,22
gefunden C 75,44 H 7,64 0 16,06.

39 45 g (0,1 Mol) des (2-Anthrachinonyl)-12-oxo-dodecanols-1 werden mit 0,15 Mol Triäthylamin in 300 ml Tetrahydrofuran unter Rühren und Inertgas gelöst. Bei 10°C lässt man 0,11 Mol Methacrylsäurechlorid in 20 ml Tetrahydrofuran zutropfen. Nach drei Stunden Rühren wird das Lösungsmittel abgezogen, der Rückstand in Methylenchlorid aufgenommen und mit wässriger Citronensäure extrahiert. Nach dem Trocknen und Einengen der organischen Phasen verbleiben 36,7 g (79,34% d.Th.) (2-Anthrachinonyl)-16-oxa-4-oxa-3-oxo-2-methyl-hexadecen-1.

Smp. 66°C (unkorrigiert).

Analyse: berechnet C 75,30 H 7,41 0 17,29
gefunden C 75,20 H 7,66 0 17,10.

**Beispiel 11: Herstellung von (2-Anthrachinonyl)-7-oxa-4-oxa-3-oxo-2-methyl-octen-1**

10 g (0,039 Mol) 2-Chlormethylanthrachinon (hergestellt nach der Vorschrift von G. Izoret, Ann.Chim. 7, 151 (1962)) werden in 200 ml Aethylenglykol unter Rühren und Feuchtigkeitsausschluss 3 Stunden zum Rückfluss erhitzt. Das beim Abkühlen auskristallisierte Produkt wird mit Wasser gewaschen und aus Aethanol umkristallisiert. Man erhält 8,9 g (80,92% d.Th.) 2-(2-Hydroxyäthoxymethyl)-anthrachinon. 8 g (0,03 Mol) 2-(2-Hydroxyäthoxymethyl)-anthrachinon werden in 180 ml Tetrahydrofuran gelöst, mit 4,34 ml Triäthylamin (0,05 Mol) versetzt und auf 5°C abgekühlt. Dann lässt man unter Rühren und Inertgas 3 ml (0,03 Mol) Methacrylsäurechlorid in 10 ml Tetrahydrofuran so zutropfen, dass die Temperatur 5°C nicht übersteigt. Nach Beendigung des Zutropfens lässt man bei Raumtemperatur 5 Stunden ausrühren. Das Lösungsmittel wird dann am Rotationsverdampfer abgezogen, und das feste Produkt wird mehrfach mit 1%iger Citronensäure und Wasser gewaschen und im Vakuum getrocknet. Man erhält 7,76 g (2-Anthrachinonyl)-7-oxa-4-oxa-3-oxo-2-methyl-octen-1 und 7,48 g (71 17 % d.Th.) nach dem Umkristallisieren aus Aethanol.

Analyse: berechnet C 71,99 H 5,18 0 22,83
gefunden C 72,25 H 5,04 0 22,58.

Smp. 90°C (unkorrigiert).

## B) Herstellung der Polymeren

**Beispiele 12-22:**

Je 600 ml einer 20%igen (Gew.%) Lösung der in den untenstehenden Tabellen I und II angegebenen Monomeren in Dioxan werden unter Lichtausschluss, Inertgas und Rühren bei 70°C mit 0,5 Gew.% Azoisobutyronitril versetzt. Nach 18 Stunden bei 70°C werden die Polymeren durch Ausfällen in Diäthyläther isoliert.

**Tabelle I:**

| Beispiel Nr. | Anthrachinonderivat nach Bsp. Nr. | Gehalt des Copolymeren an Methacrylsäure-2-hydroxyäthylester in Mol% | Grenzviskosität (η) dl/g gemessen bei 25°C in DMF | Glasumwandlungstemp. Tg °C |
|---|---|---|---|---|
| 12 | 1 | 99 | 0,23 | 80 |
| 13 | 1 | 95 | 0,21 | 84 |
| 14 | 1 | 85 | 0,11 | 65 |

Tabelle II:

| Beispiel Nr. | Anthrachinonderivat nach Beispiel Nr. | Gehalt des Copolymeren an Methacrylsäure-2-hydroxyäthylester Mol% | Gehalt des Copolymeren an Acrylsäure-2-äthylhexylester Mol% | Grenzviskosität [η] dl/g bei 25°C in DMF | Glasumwandlungstemperatur Tg °C |
|---|---|---|---|---|---|
| 15 | 1 | 65 | 31,5 | 0,25 | 38 |
| 16 | 3 | 65 | 31,5 | 0,30 | 44 |
| 17 | 6 | 65 | 31,5 | 0,469 | 40 |
| 18 | 6 | 50 | 35 | 0,25 | 59 |
| 19 | 7 | 65 | 31,5 | 0,476 | 34 |
| 20 | 5 | 65 | 28 | 0,277 | 38 |
| 21 | 4 | 65 | 28 | 0,314 | 44 |
| 22 | 9 | 65 | 31,5 | 0,42 | 52 |

**Beispiel 23:**

Analog der in Beispiel 12 beschriebenen Arbeitsweise wird ein Terpolymer aus 3,5 Mol% des Anthrachinonderivats gemäss Beispiel 1, 65 Mol% Methacrylsäure-2-hydroxyäthylester und 31,5 Mol% Vinylbenzol hergestellt. Tg des Polymeren = 82°C; [η] = 0,33 dl/g in DMF bei 25°C.

**Beispiel 24:**

Analog der in Beispiel 12 beschriebenen Arbeitsweise wird ein Terpolymer aus 1,5 Mol% des Anthrachinonderivats gemäss Beispiel 7, 75,5 Mol% Methacrylsäure-2-hydroxyäthylester und 23 Mol% Methacrylsäuremethylester hergestellt. Tg des Polymeren = 40°C; [η] = 0,24 dl/g in DMF bei 25°C.

**Beispiel 25:**

Analog der in Beispiel 12 beschriebenen Arbeitsweise wird ein Terpolymer aus 7 Mol% des Anthrachinonderivates gemäss Beispiel 7, 60 Mol% Methacrylsäure-N,N-dimethylaminoäthylester und 33 Mol% Acryl-säure-2-äthylhexylester hergestellt. Tg des Polymeren = 51°C; [η] = 0,42 dl/g in DMF bei 25°C.

**Beispiel 26:**

Ein Gemisch aus m- und p-Vinylbenzylalkohol wird nach der Vorschrift von C.H. Bamford und H. Lindsay [Polymer 14,330 (1973)] hergestellt. Zur Herstellung eines lichtempfindlichen Polymeren werden 8,75 g (26 mMol) des m-/p-Methylstyryl-2-anthrachinonyläthers, 32,02 g (239 mMol) m-/p-Vinylbenzylalkohol und 10,71 g (103 mMol) Aethenylbenzol in 450 ml Dioxan unter Rühren und Inertgas bei 70°C mit 0,257 g Azoisobutyronitril versetzt und 12 Std. gerührt. Das Polymer wird durch Fällung in Wasser isoliert. Ausbeute 17 14 g.

**Beispiele 27-30:**

Analog dem in Beispiel 12 beschriebenen Verfahren werden aus 1,383 Mol Methacrylsäure-hydroxypropylester (Gemisch aus Methacrylsäure-2- und -3-hydroxypropylester) und 0,745 Mol Methacrylsäuremethylester 100,15 g eines Copolymers mit einem Tg von 1°C und einer Grenzviskosität [η] von 0,642 dl/g in DMF bei 25°C gewonnen. Je 10%ige Lösungen dieses Copolymeren in Pyridin werden jeweils mit den in der folgenden Tabelle III angegebenen Mengen Anthrachinon-2-carbonsäurechlorid unter Feuchtigkeitsausschluss versetzt und 12 Std. bei 50°C gerührt. Das Polymer wird durch Fällen in Diäthyläther isoliert. Die Resultate sind in der Tabelle III zusammengefasst.

**Tabelle III:**

| Beisp. Nr. | g Polymer | g Anthrachinon-2-carbonsäurechlorid | Anthrachinongehalt [1) ] $\eta_{max}$ = 325 nm | Mol% an Strukturelementen (I) | Tg °C des Polymeren |
|---|---|---|---|---|---|
| 27 | 25 | 1,8 | 6,55 Gew.% | 3,4% | 89 |
| 28 | 11,51 | 3,25 | 27,61 Gew.% | 17% | 86 |
| 29 | 11,51 | 4,06 | 33,60 Gew.% | 27% | 89 |
| 30 | 11,51 | 5,41 | 41,86 Gew.% | 35% | 92 |

1) aus Extinktion $\eta_{325}$ nm berechnet.

**C) Anwendungsbeispiele:**

**Beispiel 31:**

Erzeugung von Abbildungen mit komplexierten Polymeren In einer 30%igen (Gew.%) Lösung der in Tabelle IV angegebenen Polymeren in DMP wird die dem Anthrachinongehalt äquimolare Menge Kupferacetat oder eines Gemisches aus Kupferacetat und Kupfer(II)bromid gelöst. Die entstandene Kupfer-Polymerkomplexlösung wird mittels einer Drucknutsche durch ein 0,5 µm Filter filtriert. Auf einer 125 µm starken Polyesterfolie (Mylar -A® der Fa. DuPont) werden mit einem Rollercoater Filme mit einer Nassfilmdicke zwischen 12 und 50 µm gezogen. Nach dem Ablüften und Trocknen bei 70°C in einem Umluftofen werden die Filme auf einem temperierbaren Vakuumrahmen durch eine Photomaske (Stufenkeil 21-Step-Sensitivity Guide Stouffer) mit einer 5kW Quecksilberlichtquelle (Fa. W.Staub AG, Neu-Isenburg, BRD) belichtet. Es resultiert ein sichtbares nichtleitendes Bild, das in einem Kupferabscheidungsbad der folgenden Zusammensetzung:

Kupfersulfat 12 g/l
Formaldehyd 8 g/l
NaOH 15 g/l
Natrium-Kaliumtartrat 14 g/l
Aethylendiamintetraessigsäure 20 g/l
(Octylphenol)-polyäthylenglykoläther n ~ l
(Tryton X 100® der Fa. Röhm + Haas) 1 g/l
bei 49°C zu einem metallischen, elektrisch leitenden Kupferbild verstärkt wird.
Die Resultate und Bedingungen sind in der folgenden Tabelle IV angegeben.

**Tabelle IV:**

| Polymer nach Beispiel Nr. | Nassfilmdicke µm | molares Verhältnis $CuBr_2$: $Cu(C_2H_5O_2)_2 \cdot H_2O$ | Belichtungstemperatur °C | letzte abgebildete Stufe nach 90 Sekunden |
|---|---|---|---|---|
| 13 | 24 | 0,11 | 90 | 4 |
| 14 | 50 | 0 | 90 | 2 |
| 23 | 50 | 0 | 90 | 3 |
| 15 | 50 | 0,20 | 90 | 4 |
| 16 | 24 | 0 | 60 | 2 |
| 17 | 50 | 0 | 90 | 3 |
| 18 | 50 | 0,11 | 80 | 2 |
| 19 | 24 | 0 | 60 | 5 |
| 24 | 24 | 0,11 | 75 | 4 |
| 21 | 50 | 0,11 | 90 | 4 |
| 20 | 12 | 0,11 | 90 | 5 |
| 25 | 24 | 0,11 | 70 | 2 |
| 22 | 24 | 0,11 | 70 | 3 |
| 26 | 24 | 0 | 90 | 2 |
| 27 | 24 | 0 | 90 | 3 |
| 28 | 24 | 0 | 90 | 5 |

**Beispiel 32: Erzeugung von Abbildungen mit nicht komplexierten Polymeren**

Zur Prüfung nicht-komplexierter erfindungsgemässer Polymerer für die sogenannte physikalische Entwicklung werden Polyesterfolien (Mylar-A® der Fa. DuPont) mit den in der folgenden Tabelle V angegebenen Polymeren wie in Beispiel 31 beschrieben beschichtet, belichtet und anschliessend mit dem Kupferabscheidungsbad behandelt.

Die Resultate und Bedingungen sind in der Tabelle V angegeben.

**Tabelle V:**

| Polymer nach Beispiel Nr. | Nassfilmdicke µm | Belichtungs-temperatur °C | letzte abgebildete Stufe nach 90 Sekunden |
|---|---|---|---|
| 22 | 12 | 50 | 8 |
| 18 | 12 | 40 | 5 |
| 28 | 24 | 30 | 8 |
| 29 | 24 | 30 | 10 |
| 30 | 24 | 30 | 6 |

**Patentansprüche**

1. Polymere mit einer Grenzviskosität [η] von mindestens 0,10 dl/g gemessen bei 25°C in N,N-Dimethylformamid, die aus 1 bis 40 Mol% wiederkehrenden Strukturelementen der Formel I

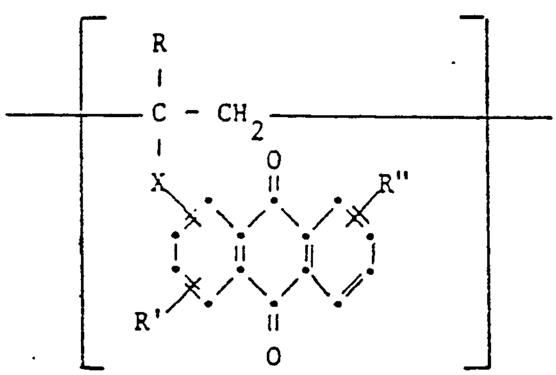

(I)

und 60 bis 99 Mol.% wiederkehrenden Strukturelementen der Formel II

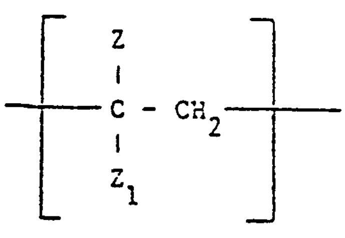

(II)

bestehen, worin
R Wasserstoff, Methyl oder Aethyl,
R' und R'' unabhängig voneinander Wasserstoff, $C_1$-$C_4$-Alkyl, Halogen, Nitro oder Methoxy,

X -COO-, -CO-O-$(CH_2)_n$-, -CO-O-$[(CH_2)_n$-O$]_r$-$CH_2$, -CO-O-$[(CH_2)_n$-O$]_r$-, -CO-O-$[CH_2CH(CH_3)O]_n$-, Phenylen-$CH_2$-O-, -CO-O-$[(CH_2)_n$-O$]_r$ -CO-, CO-O-$[CH_2CH(CH_3)$-O$]_n$ — CO-, -CO-NR-, Phenylen-$CH_2$-O-$[(CH_2)_n$-O$]_r$-$(CH_2)_m$-, Phenylen-$CH_2$-O-$[(CH_2)_n$-O$]_r$-CO-, -$COOCH_2CH(OH)CH_2OCO$-,
-$COOCH_2CH(OH)CH_2O$- oder -CO-O-$[CH_2CH(CH_3)O]_r$ — $CH_2$-,
m Null oder 1,
n eine ganze Zahl von 1-12,
r eine ganze Zahl von 1-4,
Z Wasserstoff, Chlor oder Methyl,
$Z_1$ Wasserstoff, Chlor, Methyl, -CN, -COOH, -$CONH_2$, Phenyl, Methylphenyl, Methoxyphenyl, Cyclohexenyl, Imidazolyl, Pyrrolidonyl, -COO-Alkyl mit 1-12 C-Atomen im Alkyl, -COOPhenyl, -$COOCH_2$

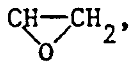

-COO-Alkylen-OH mit 2-12 C-Atomen im Alkylen,
-$COO(CH_2CH_2O)_p$-H oder -$COO[CH_2CH(CH_3)O]_p$-H mit p =2-4,
-OCOAlkyl mit 1-4 C-Atomen im Alkyl,-OCOPhenyl, -COAlkyl mit 1-4 C-Atomen im Alkyl, $C_{1-12}$-Alkoxy, Phenoxy, Hydroxymethylphenyl, -CONH-$C_{1-4}$-Alkylen-OH oder -COO-$C_{1-4}$-Alkylen-N(Q')(Q''),
Q, Wasserstoff oder $C_{1-5}$-Alkyl und Q'' $C_{1-5}$-Alkyl darstellen, wobei $Z_1$ in mindestens 20 % der Strukturelemente der Formel II
-COO-$C_{2-12}$-Alkylen-OH, -$COO(CH_2CH_2O)_p$-H, -$COO[CH_2CH(CH_3)O]_p$-H, Hydroxymethylphenyl, -CONH-$C_{1-4}$-Alkylen-OH oder -COO-$C_{1-4}$-Alkylen-N-(Q')(Q'') bedeutet und die Strukturelemente der Formel II mindestens teilweise mit Metallionen eines Metalls der Gruppe VIII oder Ib des Periodensystems komplexiert sein können, mit der Massgabe, dass $Z_1$, wenn X -CO-O-$CH_2$- darstellt, in höchstens 80 % der Strukturelemente der Formel II -$COOCH_2CH_2OH$ darstellt.

2. Polymere nach Anspruch 1, die aus 1 bis 15 Mol % wiederkehrenden Strukturelementen der Formel I und 85 bis 99 Mol % wiederkehrenden Strukturelementen der Formel II bestehen, worin R, R', R'', m, n, r und Z die im Anspruch 1 angegebene Bedeutung haben, $Z_1$ dieselbe Bedeutung wie in Anspruch 1 hat, aber ungleich -$COO(CH_2CH_2O)_p$-H oder
-$COO[CH_2CH(CH_3)O]_p$-H ist, X dieselbe Bedeutung wie in Anspruch1 hat, aber ungleich -$COOCH_2CH(OH)CH_2O$-, -$COOCH_2CH(OH)CH_2OCO$- oder
-$COO[CH_2CH(CH_3)O]_r$-$CH_2$- ist und $Z_1$ in mindestens 40 %der Strukturelemente der Formel II -COO-$C_{2-12}$-Alkylen-OH, Hydroxymethylphenyl,
-CONH-$C_{1-4}$-Alkylen-OH oder -COO-$C_{1-4}$-Alkylen-N(Q')(Q'') bedeutet.

3. Polymere nach Anspruch 1, worin die Strukturelemente der Formel II mindestens teilweise mit Eisen-, Kobalt-, Nickel- oder Kupferionen komplexiert sind.

4. Polymere nach Anspruch 1, worin die Strukturelemente der Formel II mindestens teilweise mit $Cu^{++}$-Ionen komplexiert sind.

5. Polymere nach Anspruch 1, worin X in 2-Stellung an den Anthrachinonrest gebunden ist, R Wasserstoff und insbesondere Methyl, R' und R'' je Wasserstoff,
X -COO-, -$COO[CH_2CH(CH_3)$-O$]_n$- oder -COO-$[(CH_2)_n$-O$]_r$- mit n = 1-11,
-COO-$CH_2$-, -COO-$[(CH_2)$n-O$]_r$CO- oder -$COO[(CH_2)_n$ O$]_r$-$CH_2$-mit n, 2-8, oder Phenylen-$CH_2$-0- bedeuten, wobei r vorzugsweise 1 ist.

6. Polymere nach Anspruch 1, worin $Z_1$ in 20 bis 97,5 und insbesondere 20 bis 70% der Strukturelemente der Formel II -COO-$C_{2-12}$-Alkylen-OH, Hydroxymethylphenyl, -CONH-$C_{1-4}$-Alkylen-OH, -COO-$C_{1-4}$-Alkylen-N(Q)(Q''), -$COO(CH_2CH_2O)$-$_p$-H oder -$COO[CH_2CH(CH_3)O]_p$-H bedeutet.

7. Polymere nach Anspruch 1, worin Z Wasserstoff, Chlor oder Methyl und $Z_1$ Wasserstoff, Chlor, -CN, Methyl, Phenyl, Methylphenyl, Methoxyphenyl, -COO-$C_{1-10}$-Alkyl, -COOPhenyl, -$COOCH_2$

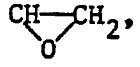

-COO-$C_{2-12}$-Alkylen-OH, -COAlkyl mit 1-4 und besonders 1 oder 2 C-Atomen, Alkoxy mit 1-8 und besonders 1-4 C-Atomen, Phenoxy, Hydroxymethylphenyl, -$CONH(CH_2)_2$-OH oder -COO-$C_{1-4}$-Alkylen-N($C_{1-4}$-Alkyl$)_2$ darstellen wobei der Anteil an Gruppen $Z_1$ = -COO-$C_{2-12}$-Al-kylen-OH, Hydroxymethylphenyl, -$CONH(CH_2)_2$-OH oder -COO-$C_{1-4}$-Alkylen-N ($C_{1-4}$-Alkyl$)_2$ 20 bis 70% beträgt.

8. Polymere nach Anspruch 1, worin Z Wasserstoff oder Methyl und $Z_1$ Methyl, Phenyl, Methylphenyl, -COO-$C_{1-10}$-Alkyl, -COO-$C_{2-12}$-Alkylen-OH, Hydroxymethylphenyl oder -COO-$C_{1-4}$-Alkylen-$N(CH_3)_2$ darstellen, wobei der

Anteil an Gruppen $-COO-C_{2-12}$-Alkylen-OH, Hydroxymethylphenyl oder $-COO-C_{1-4}$-Alkylen-$N(CH_3)_2$ 20 bis 70% beträgt.

9. Polymere nach Anspruch 1 mit einer Grenzviskosität [η] von 0,30 bis 0,50 dl/g, gemessen bei 25°C in N,N-Dimethylformamid, die aus 1 bis 10 Mol% wiederkehrenden Strukturelementen der Formel I und 90 bis 99 Mol% wiederkehrenden Strukturelementen der Formel II bestehen, worin X in 2-Stellung an den Anthrachinonrest gebunden ist, R Wasserstoff oder vor allem Methyl, R' und R'' je Wasserstoff, X $-COO-$, $-COO[CH_2CH(CH_3)-O]_n-$ oder $-COO[(CH_2)_n-O]_r-$ mit n = 1-11, $-COO-CH_2-$, $-COO-[(CH_2)_n-O]_rCO-$ oder $-COO[(CH_2)_n-O]_r-CH_2-$mit n= 2-8 oder Phenylen-$CH_2$-O- und vor allem -COO- oder Phenylen-$CH_2$-O- bedeuten, wobei r 1-4 und besonders 1 ist, in 55-65% der Strukturelemente der Formel II Z Wasserstoffund besonders Methyl und $Z_1$ $-COO(CH_2)_2-N(CH_3)_2$undvor allem $-COO(CH_2)_2-OH$ und in 35-45% der Strukturelemente der Formel II Z Methyl und insbesondere Wasserstoff und $Z_1$ Phenyl oder $-COO-C_{1-8}$-Alkyl darstellen, wobei die Strukturelemente der Formel II mindestens teilweise mit Eisen-, Kobalt-, Nickel- oder Kupferionen, besonders $Cu^{++}$-Ionen, komplexiert sind.

10. Nicht-komplexierte Polymere nach Anspruch 1 mit einer Grenzviskosität [η] von 0,30 bis 0,50 dl/g, gemessen bei 25°C in N,N-Dimethylformamid, die aus 3 bis 40 Mol% wiederkehrenden Strukturelementen der Formel I und 60 bis 97 Mol% wiederkehrenden Strukturelementen der Formel II bestehen, worin X in 2-Stellung an den Anthrachinonrest gebunden ist, R Wasserstoff und vor allem Methyl, R' und R'' je Wasserstoff und X $-COO-$, $-COO[CH_2CH(CH_3)-O]_n-$ oder $-COO[(CH_2)_n-O]_r-$ mit n = 1-11, $-COO-CH_2-$, $-COO-[(CH_2)_n-0]_rCO-$ oder $-COO[(CH_2)_n-0]_r-CH_2-$ mit n = 2-8 oder Phenylen-$CH_2$-O- bedeuten, wobei r 1-4 und insbesondere 1 ist, in 20 bis 65% der Strukturelemente der Formel II Z Wasserstoff und besonders Methyl und $Z_1$ $-COO(CH_2)_2N(CH_3)_2$ und vor allem $-COO(CH_2)_2-OH$ und in 35-80% der Strukturelemente der Formel II Z Methyl und insbesondere Wasserstoff und $Z_1$ Phenyl oder $-COO-C_{1-8}$-Alkyl darstellen.

11. Verfahren zur Herstellung von Polymeren nach Anspruch 1, dadurch gekennzeichnet, dass man

a) 1 bis 40 Mol% einer Verbindung der Formel Ia

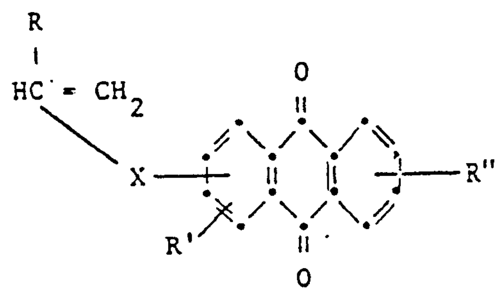

(Ia)

mit 60 bis 99 Mol% einer Verbindung der Formel IIa

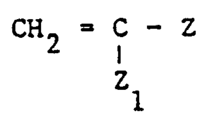

(IIa)

polymerisiert,

b) zur Herstellung von Polymeren nach Anspruch 1, worin $Z_1$ ungleich $-COOH$, $-CONH_2$, $-COO-C_{1-12}$-Alkyl, -COOPhenyl oder $-COOCH_2$

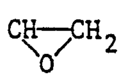

und X ungleich $-COOCH_2CH(OH)CH_2OCO-$ sind, ein Polymeres, das aus 1 bis 40 Mol% wiederkehrenden Strukturelementen der Formel Ib

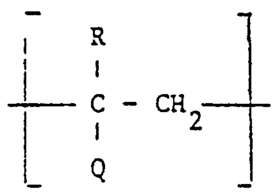

(Ib)

und 60 bis 99 Mol% wiederkehrenden Strukturelementen der Formel IIb

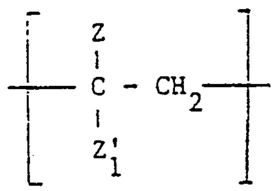

(IIb)

besteht,
mit einer Verbindung der Formel III

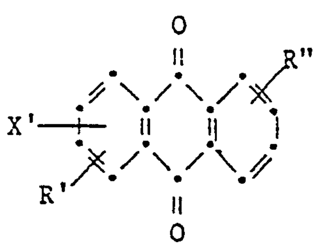

(III)

umsetzt, oder

c) zur Herstellung von Polymeren nach Anspruch 1, worin Z Wasserstoff oder Methyl und X -$COOCH_2CH(OH)CH_2OCO$-, -COO-$[(CH_2)_n$-$O]_r$-$CH_2$-, -COO-$[(CH_2)_n$-$O]_r$- CO-, -COO-$[CH_2CH(CH_3)$-$O]_r$-$CH_2$-, -$COO[CH_2CH(CH_3)O]_n$-CO-, Phenylen-$CH_2$-O-$[(CH_2)_n$-$O]_r$-$CH_2$- oder Phenylen-$CH_2$-O-$[(CH_2)_n$-$O]_r$-CO- darstellen, ein Polymeres, das aus 1 bis 40 Mol % wiederkehrenden Strukturelementen der Formel Ic

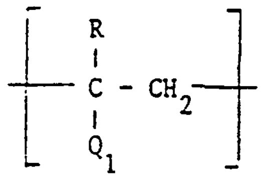

(Ic)

und 60-99 Mol% wiederkehrenden Strukturelementen der Formel IIc

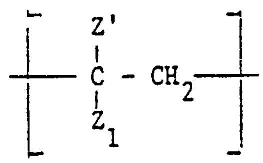

(IIc)

besteht, mit 1-40 Mol% einer Verbindung der Formel IIIa

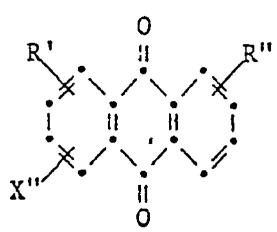

(IIIa)

umsetzt und die so erhaltenen Polymeren gegebenenfalls anschliessend mindestens teilweise mit einem Salz eines Metalls der Gruppe VIII oder Ib des Periodischen Systems komplexiert, wobei für m, n, r, R, R', R'', X, Z und $Z_1$ und den Anteil an Gruppen -COO-$C_{2-12}$-Alkylen-OH,

-COO($CH_2CH_2O)_p$-H, -COO[$CH_2CH(CH_3)]_p$-H, Hydroxyphenylmethyl,

-CONH-$C_{1-4}$-Alkylen-OH oder -COO-$C_{1-4}$-Alkylen-OH oder -COO-$C_{1-4}$-Alkylen-N'(Q')(Q'') das im Anspruch 1 Angegebene gilt,

Q -COHalogen, Phenylen-$CH_2$-Halogen oder -$COOCH_2$

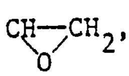,

X' HO-, HO-($CH_2$) -, HO-[$(CH_2)_n$)-O]$_r$-$CH_2$-, HO-[$(CH_2)_n$-O]$_r$-,

HO-[$CH_2CH(CH_3)$-O]$_R$-$CH_2$-, HO-]$CH_2CH(CH_3)$-O] $_n$-, HO-[$(CH_2)_n$-O]$_r$-CO-,

HO-[$CH_2CH(CH_3)$-O]$_n$- CO- oder HNR- bedeuten und $Z_1$' dieselbe Bedeutung wie $Z_1$ hat, aber ungleich -COOH, -$CONH_2$, -COO-$C_{1-12}$-Alkyl,

-COOPhenyl oder -$COOCH_2$

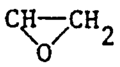

ist,
Z' Wasserstoff oder Methyl und
$Q_1$ -$COOCH_2$

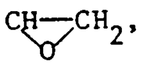

-COO-$[(CH_2)_n$-O$]_r$-H, -COO-$[CH_2CH(CH_3)$-O$]_n$-H,
-COO-$[CH_2CH(CH_3)$-O$]_r$ — H oder Phenylen-$CH_2$-O-$[(CH_2)_n$-O$]_r$-H darstellen und
X'' das folgende bedeutet: wenn $Q_1$ -$COOCH_2$

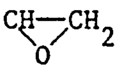

ist, -COOH; wenn $Q_1$
-COO$[(CH_2)_n$-O$]_r$-H, -COO$[CH_2CH(CH_3)$-O$]_r$-H oder
Phenylen-$CH_2$-O$[(CH_2)_n$-O$]_r$-H ist, -COOH, -COCl oder -$CH_2Cl$; wenn $Q_1$ -COO$[CH_2CH(CH_3)$-O$]_n$-H ist, -COOH oder -COCl.

12. Verfahren zur Herstellung von Polymeren nach Anspruch 11, dadurch gekennzeichnet, dass man 1-15 Mol % einer Verbindung der Formel Ia mit 85-99 Mol % einer Verbindung der Formel IIa polymerisiert oder ein Polymeres, das aus 1-15 Mol % wiederkehrenden Strukturelementen der Formel Ib und aus 85-99 Mol % wiederkehrenden Strukturelementen der Formel IIb besteht, mit einer Verbindung der Formel III umsetzt und die erhaltenen Polymeren gegebenenfalls anschliessend mindestens teilweise mit einem Salz eines Metalls der Gruppe VIII oder Ib des Periodischen Systems komplexiert, wobei für m, n, r, R, R', R'' und Z das im Anspruch 11 Angegebene gilt,
Q -COHalogen oder Phenylen-$CH_2$-Halogen und
X' HO-, HO-$(CH_2)_n$-, HO-$[(CH_2)_n$-0$]_r$-$CH_2$-, HO$[(CH_2)_n$ 0$]_r$-, HO-$[CH_2CH(CH_3)$-0$]_n$-, HO-$[(CH_2)_n$-0$]_r$-CO-, HO-$[CH_2CH(CH_3)$-0$]_n$-CO-oder HNR- bedeuten,
X dieselbe Bedeutung wie in Anspruch 11 hat, aber ungleich
-$COOCH_2CH(OH)CH_2O$-, -$COOCH_2CH(OH)CH_2OCO$- oder -COO$[CH_2CH(CH_3)O]_r$-$CH_2$- ist,
$Z_1$ dieselbe Bedeutung wie in Anspruch 11 hat, aber ungleich -$COO(CH_2CH_2O)_p$-H oder -COO$[CH_2CH(CH_3)O]_p$-H ist,
$Z'_1$ dieselbe Bedeutung wie $Z_1$ hat, aber ungleich -COOH, -$CONH_2$,
-COO-$C_{1-12}$ -Alkyl, -COOPhenyl oder -$COOCH_2$

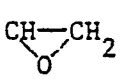

ist, und
der Anteil an Gruppen -COO-$C_{2-12}$-Alkylen-OH, Hydroxyphenylmethyl,
-CONH-$C_{1-4}$-Alkylen-OH oder -COO-$C_{1-4}$-Alkylen-N(Q')(Q'') mindestens 40 % beträgt.

13.Verfahren nach Anspruch 11 oder 12, dadurch gekennzeichnet, dass man für die Komplexierung Kupfer(II)acetat oder ein Gemisch aus Kupfer(II)acetat und Kupfer(II)bromid verwendet.

14. Verwendung von Polymeren nach Anspruch 1 oder 2 zur Bilderzeugung durch Lichteinwirkung, besonders zur Herstellung von elektrisch leitenden Ueberzügen oder Mustern.

15. Verwendung nach Anspruch 14 zur Herstellung von elektrisch leitenden Ueberzügen oder Mustern, indem man die Metallionen eines mindestens teilweise komplexierten Polymeren nach Anspruch 1 oder 2 durch Lichteinwirkung zu nullwertigen, nicht-leitenden Metallkeimen reduziert und darauf stromlos Metall abscheidet.

16. Verwendung nach Anspruch 14 zur Herstellung von elektrisch leitenden Ueberzügen oder Mustern, indem man nicht-komplexierte Polymere nach Anspruch 1 oder 2 belichtet und darauf stromlos Metall abscheidet.

17. Verbindungen der Formel Ia

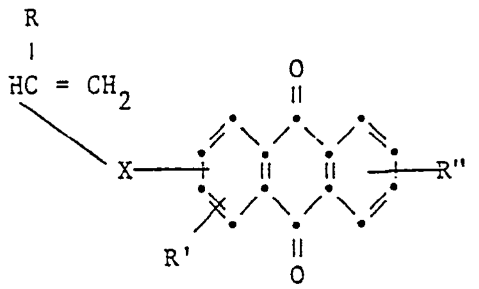

(Ia)

worin R Wasserstoff, Methyl oder Aethyl, R′ und R″ unabhängig voneinander Wasserstoff, $C_{1-4}$-Alkyl, Halogen, Nitro oder Methoxy, X $-CO-O(CH_2)_{n'}-$, $-CO-O-[(CH_2)_n-O]_r-CH_2-$, $-CO-O-[(CH_2)_n-O]_r-$, $-CO-O-[CH_2CH(CH_3)-O]_r-CH_2-$, $-CO-O-[CH_2CH(CH_3)\ O]_n-$, Phenylen-$CH_2$-O-, $-CO-O-[(CH_2)_n-O]_r-CO-$, $-CO-O-[CH_2CH(CH_3)-O]_n-CO-$, -CO-NR-, Phenylen $CH_2-O-[(CH_2)_n-O]_2-(CH_2)_m-$, Phenylen-$CH_2-O-[(CH_2)_n-O]_r-CO-$ oder $-CO-O-CH_2CH(OH)CH_2OCO-$, m null oder 1, n eine ganze Zahl von 1-12, n′ eine ganze Zahl von 2-12 und r eine ganze Zahl von 1-4 bedeuten.

18. Verbindungen der Formel Ia nach Anspruch 17, worin X ungleich $-CO-O-[CH_2CH(CH_3)-O]_r-CH_2-$ ist.

**Claims**

1. A polymer having an intrinsic viscosity [η] of not less than 0.10 dl/g, measured at 25°C in N,N-dimethylformamide, which consists of 1 to 40 mol % of recurring structural elements of the formula

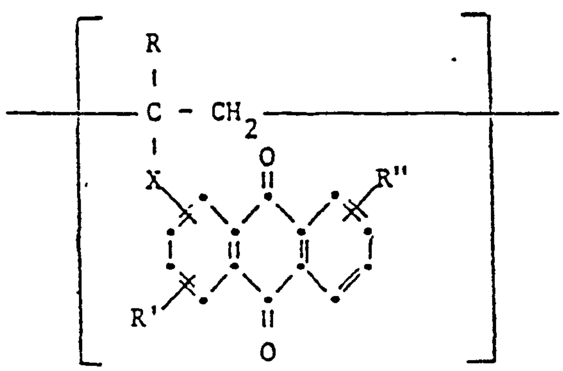

(I)

and 60 to 99 mol % of recurring structural elements of the formula

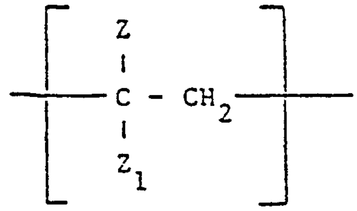

(II)

in which formulae R is hydrogen, methyl or ethyl, each of R' and R'' independently of the other is hydrogen, $C_1$-$C_4$alkyl, halogen, nitro or methoxy, X is -COO-, $-CO-O-(CH_2)_n-$, $-CO-O-[(CH_2)_n-O]_r-CH_2-$, $-CO-O-[(CH_2)_n-O]_r-$, $-CO-O-[CH_2CH(CH_3)O]_n-$, phenylene-$CH_2$-O-, $-CO-O-[(CH_2)_n-O]_r-CO-$, $-CO-O-[CH_2CH(CH_3)-O]-nCO-$,-CO-NR-, phenylene-$CH_2-O-[(CH_2)_n-O]_r-(CH_2)_m-$, phenylene-$CH_2-O-[CH_2)_n-O]_r-CO-$, $-COOCH_2CH(OH)CH_2OCO-$, $-COOCH_2CH(OH)CH_2O-$ or $-CO-O-[CH_2CH(CH_3)O]-r-CH_2-$, m is zero or 1, n is an integer from 1 to 12, r is an integer from 1 to 4, Z is hydrogen, chlorine or methyl,

$Z_1$ is hydrogen, chlorine, methyl, -CN, -COOH, $-CONH_2$, phenyl, methylphenyl, methoxyphenyl, cyclohexenyl, imidazolyl, pyrrolidonyl, -COO-alkyl having 1-12 C atoms in the alkyl moiety, -COOphenyl, $-COOCH_2$

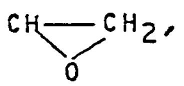

-COO-alkylene-OH

having 2-12 C atoms in the alkylene moiety $-COO(CH_2CH_2O)_p-H$ or $-COO[CH_2CH(CH_3)O]_p-H$ where p is 2-4, -OCOalkyl having 1-4 C atoms in the alkyl moiety, -OCOphenyl, -COalkyl having 1-4 C atoms in the alkyl moiety, $C_{1-12}$alkoxy, phenoxy, hydroxymethylphenyl, -CONH-$C_{1-4}$alkylene-OH or -COO-$C_{1-4}$-alkylene-N(Q')(Q''), Q' is hydrogen or $C_{1-5}$alkyl and Q'' is $C_{1-5}$alkyl, and $Z_1$ in not less than 20% of the structural elements of the formula II is -COO-$C_{2-12}$-alkylene-OH, $-COO(CH_2CH_2O)_p-H$, $-COO[CH_2CH(CH_3)O]_p-H$, hydroxymethylphenyl, -CONH-$C_{1-4}$alkylene-OH or -COO-$C_{1-4}$alkyl-ene-N-(Q')(Q''), and the structural elements of the formula II can be at least pårtly complexed with metal ions of a metal of group VIII or Ib of the periodic table, with the proviso that, if X is $-CO-O-CH_2-$, $Z_1$ is $-COOCH_2CH_2OH$ in not more than 80% of the structural elements of the formula II.

2. A polymer according to claim 1, which consists of 1 to 15 mol % of recurring structural elements of the formula I and 85 to 99 mol % of recurring structural elements of the formula II, in which formulae R, R', R'', m, n, r and Z are as defined in claim 1, $Z_1$ is as defined in claim 1, but is not $-COO(CH_2CH_2O)_p-H$ or $-COO[CH_2CH(CH_3)O]_p-H$, and

X is as defined in claim 1, but is not $-COOCH_2CH(OH)CH_2O-$, $-COOCH_2CH(OH)CH_2OCO-$ or $-COO[CH_2CH(CH_3)O]_r-CH_2-$, and $Z_1$ is -COO-$C_{2-12}$alkylene-OH, hydroxymethylphenyl, -CONH-$C_{1-4}$alkylene-OH or -COO-$C_{1-4}$alkylene-N(Q')(Q'') in not less than 40% of the structural elements of the formula II.

3. A polymer according to claim 1, wherein the structural elements of the formula II are at least partly complexed with iron, cobalt, nickel or copper ions.

4. A polymer according to claim 1, wherein the structural elements of the formula II are at least partly complexed with $Cu^{++}$ ions.

5. A polymer according to claim 1, wherein X is attached in the 2-position to the anthraquinone radical, R is hydrogen or, in particular, methyl each of R' and R'' is hydrogen,

X is -COO-, $-COO[CH_2CH(CH_3)-O]_n-$ or $-COO-[(CH_2)_n-O]_r-$, where n is 1-11, or $-COO-CH_2-$, $-COO-[(CH_2)_n-0]_rCO-$ or $-COO[CH_2)_n-O]_r-CH_2-$, where n is 2-8, or phenylene-$CH_2$-O-, and r is preferably 1.

6. A polymer according to claim 1, wherein, in 20 to 97.5%, in particular 20 to 70%, of the structural elements of the formula II, $Z_1$ is -COO-$C_{2-12}$alkylene-OH, hydroxymethylphenyl, -CONH-$C_{1-4}$alkylene-OH, -COO-$C_{1-4}$-alkylene-N(Q')(Q''), $-COO(CH_2CH_2O)_p-H$ or $-COO[CH_2CH(CH_3)O]_p-H$.

7. A polymer according to claim 1, wherein Z is hydrogen, chlorine or methyl and $Z_1$ is hydrogen, chlorine, -CN,methyl, phenyl, methylphenyl, methoxyphenyl, -COO-$C_{1-10}$alkyl,

-COO-phenyl, $-COOCH_2$

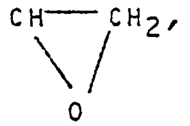

$-COO-C_{2-12}alkylene-OH$, -CO alkyl having 1-4, in particular 1 or 2, C atoms, alkoxyhaving 1-8, in particular 1-4, C atoms, phenoxy, hydroxymethylphenyl, $-CONH(CH_2)_2-OH$ or $-COO-C_{1}$ $_{4}alkylene-N(C_{1-4}alkyl)_2$, the proportion of $-COO-C_{2-12}alkylene-OH$, hydroxymethylphenyl, $-CONH(CH_2)_2-OH$ or $-COO-C_{1-4}alkylene-N(C_{1-4}alkyl)_2$ groups $Z_1$ being 20 to 70%.

8. A polymer according to claim 1, wherein Z is hydrogen or methyl and $Z_1$ is methyl, phenyl, methylphenyl, $-COO-C_{1-10}alkyl$, $-COO-C_{2-12}alkylene-OH$, hydroxymethylphenyl or $-COO-C_{1-4}$ alkylene-$N(CH_3)_2$, the proportion of $-COO-C_{2-12}alkylene-OH$, hydroxymethylphenyl or $-COO-C_{1-4}$-alkylene-$N(CH_3)_2$ groups being 20 to 70%.

9. A polymer according to claim 1 having an intrinsic viscosity [η] of 0.30 to 0.50 dl/g, measured at 25°C in N,N-dimethylformamide, and consisting of 2 to 10 mol % of recurring structural elements of the formula I and 90 to 99 mol % of recurring structural elements of the formula II,in which formulae X is attached in the 2-position to the anthraquinone radical, R is hydrogen or, in particular, methyl, each of R' and R'' is hydrogen and X is -COO-, $-COO[CH_2CH(CH_3)-O]_n-$ or $-COO[(CH_2)_n-O]_r-$, where n is 1-11, or $-COO-CH_2$, $-COO-[(CH_2)_n-O]_rCO-$ or $-COO[(CH_2)_n-O]_r-CH_2-$, where n is 2-8, or phenylene-$CH_2$-O- or, in particular,-COO- or phenylene-$CH_2$-O-, and r is 1-4, in particular 1, and, in 55 - 65% of the structural elements of the formula II, Z is hydrogen or, in particular, methyl and $Z_1$ is $-COO(CH_2)_2-N(CH_3)_2$, or, in particular, $-COO(CH_2)_2-OH$ and, in 35 - 45% of the structural elements of the formula II, Z is methyl or, in particular, hydrogen and $Z_1$ is phenyl or $-COO-C_{1-8}alkyl$, the structural elements of the formula II being at least partly complexed with iron, cobalt, nickel or copper ions, in particular $Cu^{++}$ ions.

10. A non-complexed polymer according to claim 1 having an intrinsic viscosity [η] of 0.30 to 0.50 dl/g, measured at 25°C in N,N-dimethylformamide, and consisting of 3 to 40 mol % of recurring structural elements of the formula I and 60 to 97 mol % of recurring structural elements of the formula II, in which X is attached in the 2-position to the anthraquinone radical, R is hydrogen or, in particular, methyl, each of R' and R'' is hydrogen and X is -COO-, $-COO[CH_2CH(CH_3)-O]_n-$ or $-COO[(CH_2)_n-O]_r-$, where n is 1-11, or $-COO-CH_2-$, $-COO-[(CH_2)_n-O]_r-CO-$ or $-COO[(CH_2)_n-O]_r-CH_2-$, where n is 2-8, or phenylene-$CH_2$-O-, and r is 1-4, in particular 1, and, in 20-65% of the structural elements of the formula II, Z is hydrogen or, in particular, methyl and $Z_1$ is $-COO(CH_2)_2N(CH_3)_2$ or, in particular, $-COO(CH_2)_2-OH$ and, in 35-80% of the structural elements of the formula II, Z is methyl or, in particular, hydrogen and $Z_1$ is phenyl or $-COO-C_{1-8}alkyl$.

11. A process for the preparation of a polymer according to claim 1, which process comprises

a) polymerising 1 to 40 mol % of a compound of the formula Ia

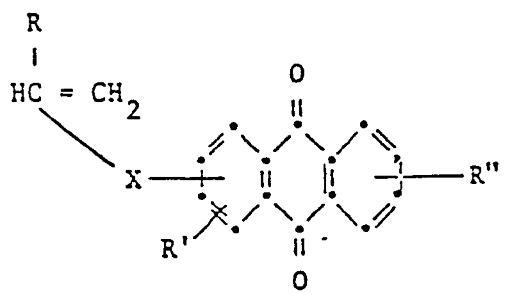

(Ia)

with 60 - 99 mol % of a compound of the formula IIa

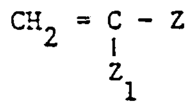

(IIa)

or

b) for the preparation of a polymer according to claim 1 in which $Z_1$ is not -COOH, $-CONH_2$, $-COO-C_{1-12}$alkyl, -COOphenyl or $-COOCH_2$

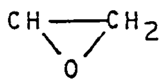

and X is not $-COOCH_2CH(OH)CH_2OCO-$, reacting a polymer consisting of 1 to 40 mol % of recurring structural elements of the formula Ib

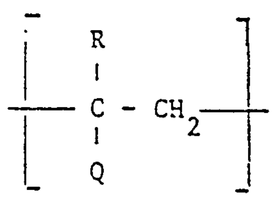

(Ib)

and 60 to 99 mol % of recurring structural elements of the formula IIb

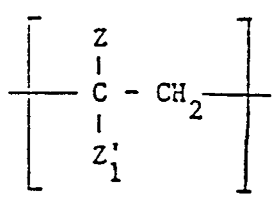

(IIb)

with a compound of the formula III

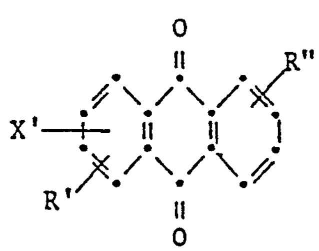

(III)

or

c) for the preparation of a polymer according to claim 1 in which Z is hydrogen or methyl and X is $-COOCH_2CH(OH)CH_2OCO-$, $-COO-[(CH_2)_n-O]_r-CH_2-$, $-COO-[(CH_2)_n-O]_r-CO-$, $-COO-[CH_2CH(CH_3)-O]_r-CH_2$ $-COO[CH_2CH(CH_3)O]_n-CO-$, -phenylene-$CH_2-O-[(CH_2)_n-O]_r-CH_2-$ or phenylene-$CH_2-O-[(CH_2)_n-O]_r-CO-$, reacting

a polymer consisting of 1 to 40 mol % of recurring structural elements of the formula Ic

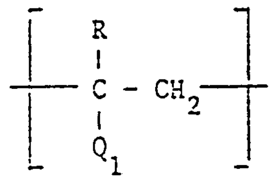

(Ic)

and 60-99 mol % of recurring structural elements of the formula IIc

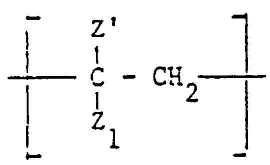

(IIc)

with 1-40 mol % of a compound of the formula IIIa

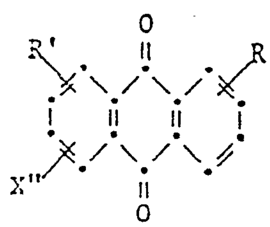

(IIIa)

and, if desired, then at least partly complexing the resultant polymer with a salt of a metal of group VIII or Ib of the periodic table, in which formulae above,
m, n. r, R, R,' R,'' X, Z and$Z_1$ and the proportion of
-COO-$C_{2\text{-}12}$alkylene-OH, -COO($CH_2CH_2O)_p$-H,
-COO[$CH_2CH(CH_3)]_p$—H, hydroxyphenylmethyl, -CONH-$C_{1\text{-}4}$-alkylene-OH, -COO-$C_{1\text{-}4}$alkylene-OH or -COO-$C_{1\text{-}4}$alkylene
N'(Q')(Q'') groups are as defined in claim 1,Q is -COhalogen, phenyl-ene-$CH_2$-halogen or -$COOCH_2$

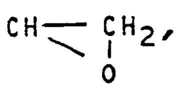

X' is HO-, HO-($CH_2)_n$-,
HO [($CH_2)_n$)-O$]_r$-$CH_2$-' HO-[($CH_2)_n$-O$]_r$-,
HO-[$CH_2CH(CH_3)$-O$]_r CH_2$-, HO-[$CH_2CH(CH_3)$ O$]_n$-,
HO-[($CH_2)_n$-O$]_r$-CO-, HO-[$CH_2CH(CH_3)$-O$]_n$-CO- orHNR-, $Z'_1$ has the same meaning as $Z_1$, with the exception of -COOH,
CONH2' COO Cl-12 yl' COOphenyl or COOCH2

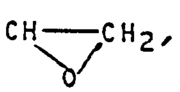

Z' is hydrogen or methyl, $Q_1$ is -$COOCH_2$

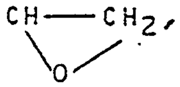

$-COO-[(CH_2)_n-O]_r-H$, $-COO-[CH_2CH(CH_3)-O]_n-H$,
$-COO-[CH_2CH(CH_3)-O]$-r – H or phenylene-$CH_2$-O-$[(CH_2)_n-O]_r$-H and, if $Q_1$ is $-COOCH_2$

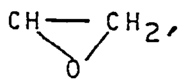

X'' is -COOH, or, if $Q_1$ is
$-COO[(CH_2)_n-O]_r-H$, $-COO[CH_2CH(CH_3)-O]_r-H$ or phenylene-$CH_2$
$-O[(CH_2)_n-O]_r-H$, X'' is -COOH, -COCl or $-CH_2Cl$, or, if $Q_1$ is
$-COO[CH_2CH(CH_3)-O]_n-H$, X'' is -COOH or -COCl.

12. A process for the preparation of a polymer according to claim 11, which comprises polymerising 1-15 mol % of a compound of the formula Ia with 85-99 mol % of a compound of the formula IIa, or reacting a polymer consisting of 1-15 mol % of recurring structural elements of the formula Ib and of 85-99 mol % of recurring structural elements of the formula IIb with a compound of the formula III, and, if desired, then at least partly complexing the resultant polymer with a salt of a metal of group VIII or Ib of the periodic table, in which formulae m, n, r, R, R', R'' and Z are as defined in claim 11, Q is -COhalogen or phenylene-$CH_2$-halogen, X' is HO-, $HO-(CH^2)^n$-' $HO-[(CH^2)^n O]^r CH^2$-,$HO[(CH^2)^n-O]^r$-,
$HO-(CH_2CH(CH_3)-O]$ -, $HO-[(CH_2)_n-O]_r$-CO-,
$HO-[CH_2CH(CH_3)-O]_n$-CO- or HNR-, X is as defined in claim 11, but is not $-COOCH_2CH(OH)CH_2O$-, -$COOCH_2CH(OH)CH_2OCO$
or $-COO[CH_2CH(CH_3)_0]_r-CH_2$-, $Z_1$ is as defined in claim-11, but is not $-COO(CH_2CH_2O)_p-H$ or -$COO[CH_2CH(CH3)O]_p$-H,
$Z'_1$ has the same meaning as $Z_1$, with the exception of
-COOH, $-CONH_2$, -COO-$C_{1-12}$alkyl, -COOphenyl or
$-COOCH_2$

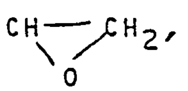

and the proportion of -COO-$C_{2-12}$ alkylene-OH,
hydroxyphenylmethyl, -CONH-$C_{1-4}$alkylene-OH or -COO-$C_{1-4}$-alkylene-N(Q')(Q'') groups is not less than 40%.

13. A process according to either of claims 11 or 12, wherein copper(II)acetate or a mixture of copper(II)acetate and copper(II)bromide is used for the complexing.

14. Use of a polymer according to either of claims 1 or 2 for producing images by the action of light, in particular for the production of electrically conductive coatings and patterns.

15. Use according to claim 14 for the production of electrically conductive coatings or patterns by reducing the metal ions of an at least partly complexed polymer according to either of claims 1 or 2 to zero-valent, nonconductive metal nuclei by the action of light,and depositing metal thereon without current.

16. Use according to claim 14 for the production of electrically conductive coatings or patterns by exposing a non-complexed polymer according to either of claims 1 or 2, and depositing a metal thereon without current.

17. A compound of the formula Ia

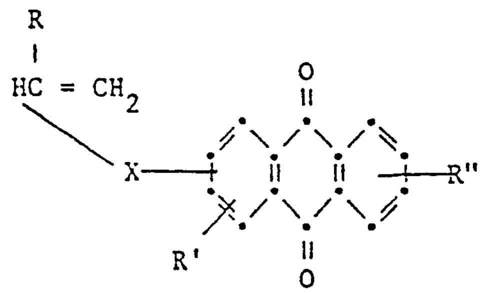

(Ia)

in which R is hydrogen, methyl or ethyl, each of R' and R'' independently of the other is hydrogen, $C_{1-4}$alkyl halogen, nitro or methoxy, X is $-CO-O(CH_2)n-$, $-CO-O-[(CH_2)_n-O]_r-CH_2-$, $-CO-O-[(CH_2)_n-O]_r-$, $-CO-O[CH_2CH(CH_3)-O]_r-CH_2-$, $-CO-O-[CH_2CH(CH_3)-O]_n-$, phenylene-$CH_2$-O-, $-CO-O-[(CH_2)_n-O]_r-CO-$, $-CO-O-[CH_2CH(CH_3)-O]_n-CO-$, -CO-NR-, phenylene-$CH_2-O-[(CH_2)_n-O]_2-(CH_2)_m-$, phenylene-$CH_2$-O $[(CH_2)_n-O]_r-CO-$ or $-CO-O-CH_2CH(OH)CH_2OCO-$, m is zeroor 1, nis an integer from 1-12, n' is an integer from 2-12 and r is an integer from 1-4.

18. A compound of the formula Ia according to claim 17, in which X is not $-CO-O-[CH_2CH(CH_3)-O]_r-CH_2-$.

**Revendications**

1. Polymères qui ont une viscosibe limite [η] d'au moins 0,10 dl/g, mesurée à 25°C dans du N,N-diméthylformamide, polymères qui sont constitués de 1 à 40 % en moles d'éléments structuraux répétés (motifs) de formule I:

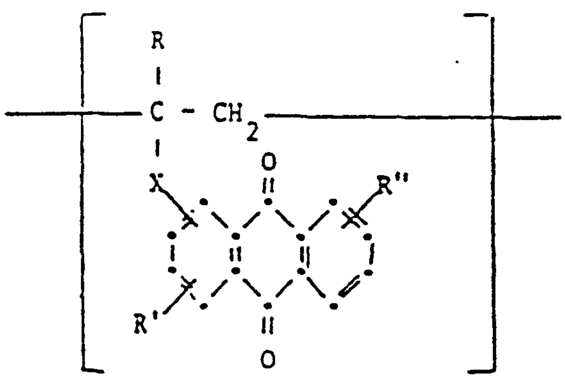

(I)

et de 60 à 95% en moles de motifs de formule II:

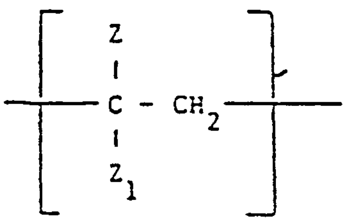

(II)

formules dans lesquelles

R représente l'hydrogène, un méthyle ou un éthyle,

R' et R'' représentent chacun, indépendamment l'un de l'autre, l'hydrogene, un alkyle en $C_1$-$C_4$, un halogène, un nitro ou un méthoxy,

X représente un radical -COO-, $-CO-O-(CH_2)_n-$,
$-CO-O-[(CH_2)_n-O]_r-C\ H_2-$, $-CO-O-[(CH_2)_n-O]_r-$,
$-CO-O-[CH_2CH(CH_3)O]_n-$, phénylène-$CH_2$-O,
$-CO-O-[(CH_2)_n-O]_r-CO$, $-CO-O-[CH_2CH(CH_3)-O]_n-CO$,
-CO-NR-, -phénylène-$CH_2-O-[(CH_2)_n-O]_r-(CH_2)_m-$,
- phénylene-$CH_2-O-[(CH_2)_n-O]_r-CO-$, $-COOCH_2CH(OH)CH_2OCO-$,
$-COOCH_2CH(OH)-$ ou $-CO-0-[CH_2CH(CH_3)O]_r\ CH_2-$,

m est égal à 0 ou à 1,

n désigne un nombre entier de 1 à 12,

r désigne un nombre entier de 1 à 4 et est de préférence égal à 1,

Z représente l'hydrogène, le chlore ou un méthyle,

$Z_1$ représente l'hydrogène, le chlore, un radical méthyle,
-CN, -COOH, $-CONH_2$, phényle, méthylphényle, méthoxyphényle, cyclohexenyle, imidazolyle, pyrrolidonyle,
-COO-alkyleà alkyle en $C_1$ à $C_{12}$, -COO-phényle,
$-COO(CH_2$

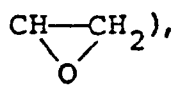

-COO-alkylène-OH à alkylène en $C_2$-$C_{12}$,
$-COO(CH_2CH_2O)_p-H$, $-COO[CH_2CH(CH_3)O]_p-H$ (où p désigne un nombre de 2 à 4), -OCO-alkyle à alkyle en $C_1$ à $C_4$,
-OCO-phényle, -CO-alkyle à alkyle en $C_1$-$C_4$, alcoxy en $C_1$-$C_{12}$, phénoxy, hydroxyméthyl -phényle,
-CONH-$C_{1\ 4}$-alkylène-OH à alkylène en $C_1$-$C_4$ ou un radical -COO-alkylene-N(Q')(Q'') dans lequel l'alkylène contient de 1 à 4 atomes de carbone, Q' représente l'hydrogène ou un alkyle en $C_1$-$C_5$ et Q'' représente un alkyle en $C_2$-$C_5$,

le symbole $Z_1$ représentant, dans au moins 20% des motifs II, un radical -COO-alkylène-OH à alkylène en $C_2$-$C_{12}$,
$-COO(CH_2CH_2O)_p-H$, $-COO[CH_2CH(CH_3)O]_p-H$, hydroxyméthylphényle, -CONH-alkylène-OH à alkylène en $C_1$-$C_4$ ou
-COO-alkylène-N(Q')(Q'') à alkylène en $C_1$-$C_4$, et les motifs de formule II pouvant être complexés, au moins partiellement, par des ions d'un métal appartenant au groupe VIII ou Ib de la classification périodique, avec la condition que $Z_1$, dans le cas où X désigne un radical
-CO-0-$CH_2$, représente un radical $-COOCH_2CH_2OH$ dans au plus 80% des motifs de formule II.

2. Polymères selon la revendication 1 qui sont constitués de 1 à 15% en moles de motifs de formule I et de 85 à 99% en moles de motifs de formule II dans lesquels R, R', R'', m, n, r et Z ont les significations données à la revendication 1, $Z_1$ a la même signification que dans la revendication 1 mais n'est ni un radical $-COO(CH_2CH_2O)_p-H$ ni un radical $-COO[CH_2CH(CH_3)O]_p-H$, X a la même signification que dans la revendication 1 sans toutefois pouvoir être un radical $-COOCH_2C_H(OH)CH_2O-$, $-COOCH_2CH(OH)CH_2OCO-$ou $-COO[CH_2CH(CH_3)O]_r-CH_2-$, et, dans au moins 40% des motifs de formule II, $Z_1$ représente un radical
-COO-alkylène-OH à alkylène en $C_2$-$C_{12}$, hydroxyméthylphényle, -CONH-alkylène-OH ü alkylene en $C_1$-$C_4$, ou -COO-alkylène-N(Q')(Q'') à alkylène en $C_1$-$C_4$.

3. Polymères selon la revendication 1 dans lesquels les motifs de formule II sont complexés, au moins partiellement,par des ions de fer, de cobalt, de nickel ou de cuivre.

4. Polymères selon la revendication 1 dans lesquels les motifs de formule II sont complexés au moins

partiellement, par des ions Cu++.

5. Polymères selon la revendication 1 dans lesquels X est lié à la position 2 du radical anthraquinonique, R représente l'hydrogène ou, mieux, un méthyle, R' et R" représentent chacun l'hydrogène, X .eprésente un radical -COO-, $-COO[CH_2CH(CH_3)-O]_n-$ ou $-COO[(CH_2)_n-O_r-$ (où n désigne un nombre de 1 à 11), $-COO-CH_2-$, $-COO-[(CH_2)_n-O[_rCO-$ou $-COO[(CH_2)_n-O_r-CH_2-$ (où n désigne un nombre de 2 à8) ou $-phénylène-CH_2-O$, l'indice r étant de préférence égal à 1.

6. Polymères selon la revendication 1 dans lesquels $Z_1$ représente, dans 20 à 97,5%, plus spécialement dans 20 à 70%, des motifs de formule II, un radical

-COO-alkylène-OH à alkylène en $C_2$-$C_{12}$, hydroxyméthylphényle, -CONH=alkylène-OH à alkylène en $C_1$-$C_4$,

-COO-alkylène-N(Q')(Q") à alkylène en $C_1$-$C_4$,

$-COO(CH_2CH_2O)_p-H$ ou $-COO[CH_2CH(CH_3)-O]_p-H$.

7. Polymères selon la revendication 1 dans lesquels Z représente l'hydrogène,le chlore ou un méthyle et $Z_1$ l'hydrogène, le chore ou un radical -CN, méthyle, phényle méthylphényle, méthoxyphényle, -COO-alkyle à alkyle en $C_1$-$C_{10}$, -COO-phényle, $-COOCH_2$

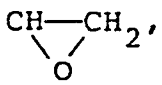

-COO-alkylène-OH à alkylène en $C_2$-$C_{12}$, -CO-alkyle dont l'alkyle contient de 1 à 4 atomes de carbone ou mieux, 1 ou 2, alcoxy en $C_1$-$C_8$, plus spécialement en $C_1$-$C_4$, phénoxy, hydroxyméthyl-phényle, $-CONH(CH_2)_2-OH$ ou

$-COO-alkylène-N(alkyle)_2$ dont l'alkylène et les alkyles contiennent chacun de 1 à 4 atomes de carbone, la proportion des $Z_1$ qui sont des radicaux -CCO-alkylène-OH à alkylène en $C_2$-$C_{12}$, hydroxyméthyl-phényle,

$-CONH(CH_2)_2-OH$ ou $-COO-alkylène-N(alkyl)_2$ à alkylène et alkyles en $C_1$-$C_4$ étant comprise entre 20 et 70%.

8. Polymères selon la revendication 1 dans lesquels Z représente l'hydrogène ou un radical méthyle et $Z_1$ un radical méthyle, phényle, méthylphényle,

-COO-alkyleà alkyle en $C_1$-$C_{10}$, - COO-alkylène-OH ü alkylene en $C_2$-$C_{12}$, hydroxyméthyl-phényle ou

$-COO-alkylène-N(CH_3)_2$ à alkylène en $C_1$-$C_4$, la proportion des radicaux -COO-alkylène-OH à alkylène en $C_2$ $C_{12}$, hydroxyméthyl-phényle ou $-COO-alkylène-N(CH_3)_2$ à alkylène en $C_1$-$C_4$ étant comprise entre 20 et 70%.

9. Polymères selon la revendication 1 qui ont une viscosité limite [η], mesurée à 25°C dans du N,N-diméthylformamide, comprise entre 0,30 et 0,50 dl/g et qui sont constitués de 1 à 10% en moles de motifs de formule I et de 90 à 99% en moles de motifs de formule II dans lesquels X se trouve en position 2 sur le radical de l'anthraquinone, R représente l'hydrogène, ou mieux, un méthyle, R' et R" représentent chacun l'hydrogène, X représente un radical -COO-, $-COO[CH_2CH(CH_3)-O]_n$; ou

$-COO[(CH_2)_n-O]_r-$ (l'indice n étant un nombre de 1 à 11),

-COO-CH, $-COO-[(CH_2)_n-O]_r-CO-$ ou $-COO[(CH_2)_n-O]_r-CH_2-$(l'indice n étant un nombre de 2 à 8) ou

$-phénylène-CH_2-O-$, plus particulièrement -COO- ou

$-phénylène-CH_2-O-$, l'indice r étant un nombre de 1 à 4, plus particulièrement le nombre 1, tandis que dans 65 à 75% des motifs de formule II le symbole Z représente l'hydrogène ou, mieux, un méthyle et $Z_1$ un radical

$-COO(CH_2)_2-N(CH_3)_2$ ou, mieux, $-COO(CH_2)_2OH$ et que, dans 35 à 45% des motifs de formule II, le symbole Z représente un méthyle ou, mieux, l'hydrogène et $Z_1$ un phényle ou un radical -COO-alkyle à alkyle en $C_1$-$C_8$, les motifs de formule II étant complexés, au moins partiellement, par des ions de fer, de cobalt, de nickel ou de cuivre, p;us spécialement par des ions Cu++.

10. Polymères non complexés selon la revendication 1 qui ont une viscosite limite [ η [, mesurée à 25°C dans du N,N-dimethylformamide, comprise entre 0,30 et 0,50 d1[g et qui sont constitués de 3 à40% en moles de motifs de formule I et de 60 à 97% en moles de motifs de formule II dans lesquels X est lié à la position 2 du radical anthraquinonique, R représente l'hydrogène ou mieux, un méthyle, R' et R" représentent chacun l'hydrogène, X représente un radical -COO-,$-COO[CH_2CH(CH_3)-O]_n$-ou $-COO[(CH_2)_n-O]_r-$ (où n désigne un nombre de 1 à 11),

$-COO-CH_2-$, $-COO[(CH_2)_n-O]_rCO-$ ou $-COO[(CH_2)_n-O]_r-CH_2-$(où n désigne un nombre de 2 à 8) ou -phénylène-$CH_2$-O l'indice r désignant un nombre de 1 à 4 et plus particulièrement le nombre 1, tandis que dans 20 à 65% des motifs de formule II le symbole Z représente l'hydrogène ou, mieux, un méthyle et $Z_1$ représente $-COO(CH_2)_2N(CH_3)_2$ ou, mieux, $-COO(CH_2)_2-OH$ et que dans 35 à 80% des motifs de formule II, le symbole Z représente un méthyle, ou, mieux, l'hydrogène et $Z_1$ un radical phényle ou -COO-alkyle à alkyle en $C_1$-$C_8$.

11. Procédé de préparation de polymères selon la revendication 1, procédé caractérisé en ce que:

a) on polymèrise de 1 à 40% en moles d'un composé de formule Ia:

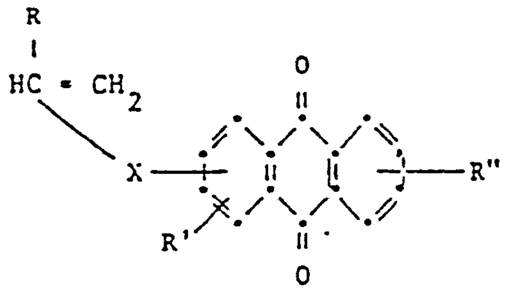

(Ia)

avec de 60 à 59% en moles d'un composé de formule IIa:

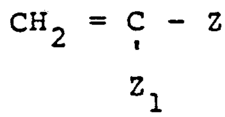

(IIa),

b) pour préparer des polymères selon la revendication 1 dans lesquels $Z_1$ n'est pas un radical -COOH, $-CONH_2$, -COO-alkyleà alkyle en $C_1$-$C_{12}$, -COO-phényle ou $-COOCH_2$

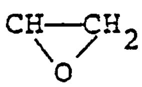

et X ne représente pas un radical $-COOCH_2CH(OH)CH_2OCO-$, on fait réagir un polymère constitué de 1 à 40% en moles de motifs de formule Ib:

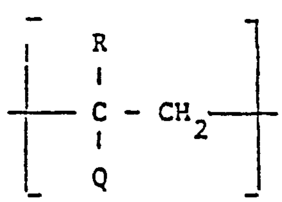

(Ib)

et de 60 à 59% en moles de motifs de formule IIb:

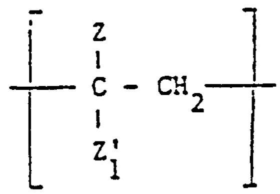 (IIb)

avec un compose de formule III

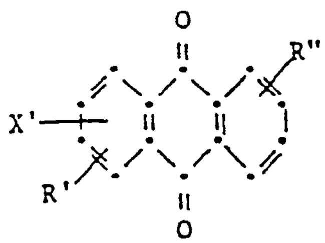 (III)

ou

c) pour préparer des polymères selon la revendication 1 dans lesquels Z représente l'hydrogène ou un méthyle et X représente un radical $-COOCH_2CH(OH)CH_2OCO-$,
$-COO-[(CH_2)_n-O]_r-CH_2$, $-COO-[(CH_2)_n-O]_r-CO-$,
$-COO-[CH_2CH(CH_3)-O]_r-CH_2-$, $-COO[CH_2CH(CH_3)O]_n-CO-$,
-phénylène-$CH_2-O](CH_2)_n-O]_r-CH_2-$ ou
-phénylène-$CH_2-O-[(CH_2)_nO]_r.CO-$, on fait réagir unpolymère constitué de 1 à 40% en moles de motifs de formule Ic:

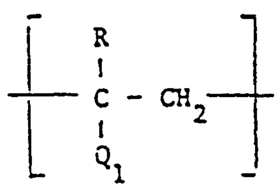 (Ic)

et de 60 à 99% en moles de motifs IIc:

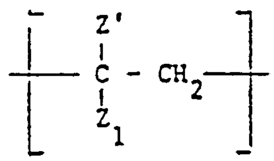

(IIc)

avec de 1 à 40% en moles d'un composé de formule III a,

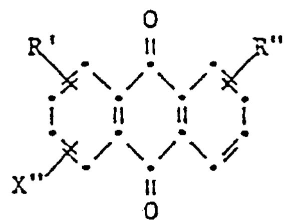

(IIIa) /

après quoi on complexe éventuellement, au moins partiellement, les polymeres ainsi obtenus au moyen d'un sel d'un métal du groupe VIII ou du groupe Ib de la classification périodique;

dans les formules précédentes

m, n, r, R, R', R'', X, Z et $Z_1$ ont lés significations données à la révéndication 1,

la proportion des radicaux -COO-alkylèné-OH à alkylène en $C_2$-$C_{12}$, -COO$(CH_2CH_2O)_p$-H,

-COO$[CH_2CH(CH_3)_p$ H, hydroxyméthylphényle,

-CONH-alkylèné-OH à alkylèné en $C_1$-$C_4$,

-COO-alkylèné-OH à alkylèné en $C_1$-$C_4$ ou

-COO-alkylène-N(Q')(Q'') à alkylèné én $C_1$-$C_4$ répond à la condition énoncée à la revéndication 1,

Q répésente un radical -CO-halogèné,

-alkylène -$CH_2$-halogèné ou

-COO$CH_2$

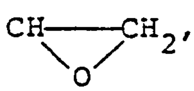

X' réprésénté un radical HO-, HO $(CH_2)_n$,

HO-$[(CH_2)$-O$]_r$-$CH_2$-, HO-$[(CH_2)_n$-O$]_r$-,

HO-$[CH_2CH(CH_3)$-O$[_r$-$CH_2$-,

HO-$[CH_2CH(CH_3)$-O$]_n$-, HO-$[ (CH_2)_n$-O$]_r$-CO-,

HO-$[CH_2CH(CH_3)$-O$[_n$-CO- ou HNR

$Z'_1$ a la même signification qué $Z_1$ sanstoutefois pouvoir répréSénter un radical

-COOH, -CON$H_2$, -COO-alkyléà alkylé én $C_1$ à $C_{12}$, -COO-phénylé ou -COO$CH_2$CH-$CH_2$

Z' représente l'hydrogéné ou un méthyle,

$Q_1$ représente un radical -COO$CH_2$

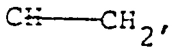

$-COO-[(CH_2)_n-O]_r-H$, $-COO-[CH_2CH(CH_3)-O]_n-H$, $-COO-[CH_2CH(CH_3)-O]_r-H$ ou phénylène-$CH_2-O-[(CH_2)O]_r-H$ ét

X'' représente:

un radical -COOH lorsqué $Q_1$ désigné un radical $-COOCH_2CH-CH_2$,

un radical -COOH, O-COCl ou $-CH_2Cl$ lorsque $Q_1$ répréséntée un radical $-COO[(CH_2CH(CH_3)-O]_r-H$, $-COO[CH_2CH(CH_3)-O]_r-H$ ou -phénylèné-$CH_2-O[(CH_2)-O]_r-H$, ou un radical -COOH ou -COCl lorsque $Q_1$ représente un radical-$COO[CH_2CH(CH_3)-O]_n-H$.

12. Procédé de préparation de polymères selon la revendication 11, procédé caractérisé en ce qu'on polymérise dé 1 à 15% en molés d'un composé de formule Ia avec de 85 à 99% én molés d'un composé de formule IIa, ou on fait réagir avéc un composé de formule III un polymère constitué de 1 à 15% én moles de motifs de formule Ib et dé 85 à 59% én moles déformule IIb, après quoi, le cas échéant, on compléxé le polymère obténu, au moins partiellemént, avéc un sél d'un métal du groupe VIII ou du groupe Ib dé la classification périodique; dans les formules qui viennént d'être méntionnées:

m, n, r, R, R', R'' ét Z ont les significations donnéés à la révendications 11,

Q réprésente un radical -CO-halogène ou -phénylèné-$CH_2$-halogène,

X' représénté un radical HO-, $HO-(CH_2)_n$, $HO-[(CH_2)_n-O]_r-CH_2-$, $HO[(CH_2)_n-O]_r-$, $HO-[CH_2CH(CH_3)-O_n-$, $HO-[(CH_2)_n-O]_r-CO-$, $HO-[CH_2CH(CH_3)-O[_r-CO-$ ou NHR-,

X a la même signification qu'à la révéndication 11 mais ne peut représenter ni un radical -$COOCH_2CH(OH)CH_2O-$, ni un radical $-COOCH_2CH(OH)CH_2OCO-$, ni un radical $-COO[CH_2CH(CH_3)O]_r-CH_2-$,

$Z_1$ a la même signification qu'à la révéndication 11 sans toutefois représenter un radical $-COO(CH_2CH_2O)_p-H$ ou $COO[CH_2CH(CH_3)O]_p-H$,

$Z'_1$ a la même signification qué $Z_1$mais ne doit pas être un radical -COOH $-CONH_2$ -COO-alkyle à alkylé én $C_1$-$C_{12}$, -COO-phényle ou $-COOCH_2$

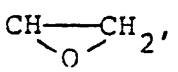

et

la proportion dés radicaux -COO-alkylèné-OH à alkylène én $C_2$-$C_{12}$, hydroxyméthyl-phény1é,-CONH-alkyléné-OH à alkylène én $C_1$-$C_4$ ou -COO-a1ky1êné-N(Q,)(Q'') à alkylèné en $C_1$-$C_4$ étant au moins égale à 40%.

13. Procédé selon l'une des revendications 11 et 12, caractérisé en ce qu'on utilise, pour le complexage, l'acétate de cuivre(II) ou un mélange d'acetate de cuivre(II) et de bromure de cuivre(II).

14. Application de polymères selon l'une des revendications 1 et 2 pour la création d'imagespar action de la lumière, en particulier eh vue de la production dé revêtements ou de dessins conducteurs de l'électricité.

15. Application selon la revendication 14 pour la production de revêtements ou de dessins électroconducteurs, application selon laquelle on reduit les ions métalliques d'un polymère au moins partiellement complexe selon l'une des revendications 1 et 2, par action de la lumière, de manière à les convertir en germes métalliques de valence nulle non conducteurs, et, sur ces germes on dépose un métal sans courant.

16. Application selon la revendication 14 pour la production de revêtements ou de dessins électroconducteurs, application selon laquelle on expose à un rayonnement des polymères non complexes selon l'une des revendications 1 et 2, et on dépose dessus un métal sans courant.

17. Composés répondant à la formule Ia

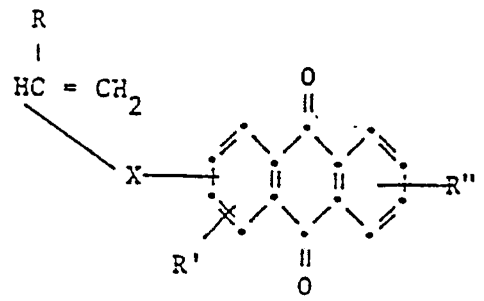

(Ia)

dans laquelle

R représente l'hydrogène, un méthyle ou un éthyle,

R' et R'' représentent chacun indépendamment l'un de l'autre l'hydrogène, un alkyle en $C_1$-$C_4$, un halogène, un radical nitro ou un radical méthoxy et

X représente un radical -CO-O $(CH_2)_n$,
-CO-O[$(CH_2$-$_n$-O]$_r$-$CH_2$-, -CO-O-[$(CH_2(_n$-O]$_r$-,
-CO-O[$CH_2CH(CH_3)$-O]$_r$-$CH_2$, -CO-O-[$CH_2CH(CH_3)$-O]$_n$-,
-phénylèné-$CH_2$-O-, -CO-O-[$(CH_2)_n$-O[$_r$-CO-,
-CO-O-[$CH_2CH(CH_3)$-O[$_n$ – CO-, -CO-NR-,
phénylène $CH_2$-O-]$(CH_2)_n$ O]$_2$ $(CH_2)_m$-,
-pénylène-CH-$_2$-O-[$(CH_2)_n$-O]$_r$-CO- ou
-CO-O-$CH_2CH(OH)CH_2OCO$-, m désignant un nombre égal à-0 ou à 1, n un nombre entier de 1 à12, n' un nombre en
tiér de 2 à 12 et r un nombré éntiér de 1 à 4.

18. Composésde formule la sélon la revéndication-17, dans lésquels X n'est pas un radical -CO-O-[$CH_2CH(CH_3)$-O]$_r$-$CH_2$-.